(19) **Europäisches Patentamt / European Patent Office / Office européen des brevets**

(11) **EP 3 197 034 B1**

(12) **FASCICULE DE BREVET EUROPEEN**

(45) Date de publication et mention de la délivrance du brevet:
**17.10.2018 Bulletin 2018/42**

(51) Int Cl.:
*H02M 7/00* (2006.01)  *H01L 23/00* (2006.01)
*H01L 25/00* (2006.01)  *H01L 27/00* (2006.01)

(21) Numéro de dépôt: **16305057.8**

(22) Date de dépôt: **22.01.2016**

(54) **CONVERTISSEUR DE PUISSANCE À DÉCOUPAGE CONFIGURÉ POUR COMMANDER AU MOINS UNE PHASE D'UN RÉCEPTEUR ÉLECTRIQUE POLYPHASÉ À AU MOINS TROIS PHASES**

LEISTUNGSWANDLER MIT KONFIGURIERTER ABSCHALTUNG ZUR STEUERUNG MINDESTENS EINER PHASE EINES MEHRPHASIGEN ELEKTRISCHEN EMPFÄNGERS MIT MINDESTENS DREI PHASEN

SWITCHING POWER CONVERTER CONFIGURED TO CONTROL AT LEAST ONE PHASE OF A POLYPHASE ELECTRICAL RECEIVER WITH AT LEAST THREE PHASES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**26.07.2017 Bulletin 2017/30**

(73) Titulaire: **THALES**
**92400 Courbevoie (FR)**

(72) Inventeurs:
• **GUILLAUME, Michel**
**1428 Lillois-Witterzee (BE)**
• **GLETON, Laurent**
**6180 Courcelles (BE)**
• **GOFFIN, Benoît**
**5081 Saint Denis (BE)**

(74) Mandataire: **Brunelli, Gérald**
**Marks & Clerk France**
**Immeuble Visium**
**22, avenue Aristide Briand**
**94117 Arcueil Cedex (FR)**

(56) Documents cités:
WO-A1-2015/008333    US-A1- 2009 285 004
US-A1- 2015 023 084    US-A1- 2015 340 962

# Description

L'invention porte sur un convertisseur de puissance configuré pour commander au moins une phase d'un récepteur électrique polyphasé à au moins trois phases.

Dans le domaine aérospatial, la tendance générale est de remplacer les actionneurs hydrauliques par des actionneurs électriques dans le but de diminuer les coûts, i.e. de mettre sur le marché des solutions économiquement plus compétitives.

En effet, le concept d'avion électrique devient une réalité avec des surfaces de contrôle qui sont actionnées par des vérins électriques, de même, pour Ariane 6, les actionneurs hydrauliques qui, sur Ariane 5, contrôlent la trajectoire du lanceur en orientant les divergents des boosters à poudre et du moteur de l'étage principal cryogénique seront remplacés par des actionneurs électriques de très haute puissance.

L'accession à de tels niveaux de puissance ne peut être obtenue que par l'élévation de la tension d'alimentation. Par exemple, pour l'étage supérieur d'Ariane 5, la puissance électrique nécessaire pour chacun des deux axes est de l'ordre 5 kW (sous 150 V) tandis que pour les étages à poudre d'Ariane 6, la puissance électrique nécessaire pour chaque axe sera de l'ordre de 70 kW (sous 330 V).

D'autre part, de nouvelles applications aérospatiales, telles que le projet Stratobus, un dirigeable autonome évoluant juste au-dessus du trafic aérien, à 20 kilomètres d'altitude, ne peuvent aboutir que dans un contexte de "tout électrique".

La criticité des missions maintenant dévolues aux actionneurs électriques impose de développer des solutions qui, tout en étant tolérantes aux pannes, ne perturbent pas la mission lors de l'occurrence d'une panne.

D'autre part, la concurrence exercée dans les marchés aérospatiaux exige de mettre en oeuvre des solutions toujours plus compétitives économiquement.

Au coeur d'un actionneur électrique se trouve une unité de commande électronique (ECPU : Electronic Control and Power Unit); la partie qui pilote le moteur électrique est constituée d'un onduleur de puissance dont les différents modes de panne ne peuvent affecter la mission.

L'électronique de puissance dans les applications à haute fiabilité comme l'aérospatiale, a besoin d'architectures capables de remplir la mission en cas de panne simple.

En d'autres termes, il est nécessaire d'apporter une solution compétitive qui garantit une continuité de service en cas de panne d'un composant électronique, sans reconfigurer et sans dégrader les performances de l'onduleur.

Il est notamment connu deux familles d'onduleurs pour réaliser un onduleur tolérant aux pannes.

Il est connu des onduleurs reconfigurables, dans lesquels des fusibles sont ajoutés en série avec les interrupteurs de puissance, voire des interrupteurs de puissance dans les lignes de phase pour forcer la fonte des fusibles dans certains cas de panne, voire des interrupteurs de puissance pour isoler la phase en panne et la commuter sur un bras d'onduleur de réserve.

Ce type d'architecture suppose qu'une panne simple n'a pas entraîné de propagation de panne sur les autres composants de l'onduleur, voire de court-circuit de la batterie, que toutes les pannes potentielles peuvent être identifiées sans ambiguïté, que les fusibles s'ouvrent dans tous les cas et que les interrupteurs de reconfiguration ne nécessitent pas une implantation plus complexe que la redondance des bras d'onduleur.

En outre, le fonctionnement de ces onduleurs suppose de disposer des moyens de détection de la panne et de conduire l'action appropriée de reconfiguration de l'onduleur qui en inhibe temporairement le fonctionnement.

Ainsi, les applications qui demandent une disponibilité totale de l'onduleur ne pourront utiliser ce type d'architecture car, dès l'occurrence d'une simple panne, le fonctionnement de l'onduleur est dégradé, voire arrêté, et ce manque de disponibilité dure le temps nécessaire à la détection de la panne, à l'identification de l'action corrective à mener et à la conduite de l'action corrective. Dans le cas d'Ariane 6, la mission d'un étage à poudre dure environ deux minutes et vingt secondes durant lesquelles le lanceur quitte le pas de tir pour atteindre une altitude de 70 kilomètres. Une telle mission demande une disponibilité permanente des équipements.

Un moyen connu de gestion des risques de panne consiste à concevoir des onduleurs avec redondance se basant sur la multiplication des composants actifs pour que la panne d'un composant soit compensée, de manière naturelle, par un composant redondant. Pour se prémunir des différents cas de panne, ce type d'architecture conduit à quadrupler les composants :

- pour éviter l'effet de la panne en court-circuit d'un composant, un second composant est ajouté en série ; s'il s'agit d'un composant commandé, la commande est également doublée.
- pour éviter l'effet de la panne en circuit ouvert d'un composant, un second composant est ajouté en parallèle ; s'il s'agit d'un composant commandé, la commande est également doublée.

De même, dans les convertisseurs de puissance à découpage embarqués dans les satellites, les architectures des cellules de commutation doivent pouvoir compenser de manière naturelle la panne d'un composant.

Le défaut majeur de ces solutions est la multiplication des composants qui augmente les coûts et, en augmentant la taille de l'implantation, en augmente également les inductances parasites qui génèrent des surtensions de commutation.

La présente invention vise à pallier les inconvénients précédemment cités et, particulièrement le problème de la tolérance aux pannes sans reconfiguration ni dégradation des performances de l'onduleur.

Il est proposé, selon un aspect de l'invention, un convertisseur de puissance à découpage (tel un onduleur ou un hacheur) configuré pour commander au moins une phase d'un récepteur électrique polyphasé à au moins trois phases (tel un moteur électrique, ou un transformateur électrique), selon la revendication 1.

Ainsi, lors de son fonctionnement, le demi-bras d'onduleur est parcouru par le courant de phase, en alternance, dans les interrupteurs en série puis, partagé en deux, dans les deux séries de diodes. La disposition des interrupteurs entre les diodes permet de créer un même chemin moyen du courant, que ce courant circule dans la série d'interrupteurs ou, partagé en deux, dans les deux séries de diodes. Par ce fait, le champ magnétique développé autour du demi-bras d'onduleur par la circulation du courant, varie peu et, l'inductance parasite de commutation est ainsi réduite au minimum. Les surtensions au niveau des diodes et des interrupteurs s'en trouvent ainsi réduites au minimum. Ainsi, les raccordements des demi-bras d'onduleur sont effectués avec un minimum d'inductance parasite de manière à réduire les surtensions générées lors de la commutation sur les interrupteurs et les diodes. En effet, le point de sommation des courants commutés dans l'interface de puissance est centré par rapport à la connexion des interrupteurs et des diodes, le reste de l'interface de puissance étant parcouru par le courant de phase. Les lignes d'alimentation coplanaires ayant une très faible inductance parasite, l'alimentation des demi-bras d'onduleur est assurée avec un minimum de surtension lors de la commutation.

D'autre part, un récepteur électrique polyphasé ayant au minimum trois phases indépendantes possède, par nature, une redondance de phase.

Aussi, il est possible de concevoir un convertisseur de puissance qui exploite cette propriété du récepteur électrique de telle manière qu'une panne en circuit ouvert du convertisseur ou du récepteur soit compensée par la nature redondante du récepteur; cette approche permet de limiter la redondance, pour le convertisseur, à une redondance série qui demande donc moitié moins de composants qu'une redondance série-parallèle classique.

Dans un mode de réalisation, les interrupteurs du premier ensemble sont alignés et/ou les diodes du deuxième ensemble sont alignées et/ou les diodes du troisième ensemble sont alignées.

Ainsi, la différence de chemin moyen du courant entre les interrupteurs et les deux séries de diodes est minimisée, réduisant au minimum l'inductance parasite de commutation et donc, les surtensions au niveau des diodes et des interrupteurs.

Dans un mode de réalisation, deux demi-bras formant un bras d'un bloc de deux bras du convertisseur, comprennent:

- un demi-bras positif comprenant l'ensemble de N interrupteurs en série connectés entre la ligne positive de l'alimentation électrique coplanaire et l'interface de puissance correspondante, et les deux ensembles de N diodes connectées entre la ligne négative de l'alimentation électrique coplanaire et l'interface de puissance correspondante, et
- un demi-bras négatif comprenant l'ensemble de N interrupteurs en série connectés entre la ligne négative de l'alimentation électrique coplanaire et l'interface de puissance correspondante, et les deux ensembles de N diodes connectées entre la ligne positive de l'alimentation électrique coplanaire et l'interface de puissance correspondante.

Selon un mode de réalisation, un demi-bras positif d'un bras d'un bloc de deux bras du convertisseur est disposé en vis-à-vis d'un demi-bras négatif d'un autre bras du convertisseur, par rapport à l'alimentation électrique coplanaire.

Ainsi, lors de la commutation, ces deux demi-bras s'échangent du courant électrique, d'une part, le courant de phase à travers leurs interfaces de puissance et la phase du récepteur et, d'autre part, des courants commutés à travers les lignes coplanaires d'alimentation. La disposition en vis-à-vis des deux demi-bras d'onduleur permet d'optimiser et de réduire la longueur de la circulation des courants commutés dans les lignes coplanaires de manière à réduire les inductances parasites et les surtensions de commutation qui leur sont liées.

Dans un mode de réalisation, lorsque le nombre de bras est impair, le convertisseur comprend desdits blocs de deux bras, et un bloc de deux bras muni d'un bras additionnel.

Ainsi, la réalisation de l'onduleur à nombre de bras impairs est conduite de manière à réduire les inductances parasites et les surtensions de commutation liées.

Selon un mode de réalisation, ledit bloc de deux bras est muni d'un bras additionnel comprenant deux demi-bras disposés de part et d'autre de l'alimentation électrique coplanaire prolongée, et une interface de puissance dudit bras additionnel comprenant respectivement, pour chacun des deux demi-bras, une partie disposée de sorte que le demi-bras correspondant est situé entre l'alimentation électrique coplanaire et ladite partie de l'interface de puissance correspondante.

Ainsi, la réalisation de l'onduleur à nombre de bras impair peut être dérivée d'une réalisation à deux bras d'onduleurs; l'ajout du troisième bras revient à dupliquer l'implantation d'une paire de demi-bras en vis-à-vis, permettant ainsi d'exploiter des outillages de fabrication développés pour une réalisation à deux bras d'onduleurs.

En variante, ledit bloc de deux bras muni d'un bras additionnel comprend, en outre, une portion additionnelle d'alimentation électrique coplanaire disposée à une extrémité et dans une direction différente du reste de l'alimentation électrique coplanaire, et une interface de puissance dudit bras additionnel disposée de sorte que ledit bras additionnel est situé entre ladite portion additionnelle d'alimentation électrique coplanaire et ladite interface de puissance correspondante.

Ainsi, ce mode de réalisation permet de simplifier l'interface de puissance du bras additionnel.

Par exemple, ladite portion additionnelle d'alimentation électrique coplanaire est sensiblement perpendiculaire au reste de l'alimentation électrique coplanaire.

Ainsi, les chemins de circulation des courants de commutation des deux demi-bras du bras additionnel dans les lignes d'alimentation coplanaires sont symétriques, de manière à ce que le fonctionnement du bras d'onduleur soit indépendant du sens du courant de phase.

Dans un mode de réalisation, le convertisseur de puissance à découpage est hybride.

Ainsi, l'utilisation des technologies hybrides permet de maximiser la compacité de l'onduleur ; une solution compacte, par la réduction des longueurs, permet de réduire fortement les inductances parasites et les surtensions qui leur sont liées. D'autre part, l'augmentation de la compacité de la réalisation permet d'en réduire la masse et, en utilisant moins de place dans l'équipement final, permet d'en réduire également la masse.

On entend par convertisseur hybride, un module comprenant un ou plusieurs substrats isolés, généralement en céramique, sur lesquels des composants actifs et passifs sont interconnectés dans le but de réaliser une fonction électrique ; les composants actifs pouvant être des puces nues ou des composants encapsulés, les composants passifs pouvant être imprimés sur le substrat ou être des composants à montage de surface. Dans tous les cas, le report des composants se fait en surface. Les substrats sont encapsulés dans un boitier au travers duquel des interconnexions permettent d'accéder à la fonction électrique interne du module.

Selon un mode de réalisation, les interrupteurs comprennent au moins un transistor bipolaire à grille isolée et/ou au moins un transistor à effet de champ à grille isolée.

Ainsi, la commande de l'interrupteur est simplifiée; lorsque la grille est polarisée, l'interrupteur est actif, lorsque la grille est dépolarisée, l'interrupteur est inhibé. Le circuit de commande est alors assez simple puisqu'il doit injecter des charges électriques dans la grille pour activer l'interrupteur et retirer ces charges pour l'inhiber. D'autre part, l'inhibition de l'interrupteur n'étant fonction que de la commande de la grille, au contraire du thyristor, par exemple, l'interrupteur peut être utilisé, de manière indifférente, dans des topologies à commutation naturelles, c'est-à-dire celles où l'interrupteur est ouvert lorsque le courant qui le traverse s'annule, et dans des topologies à commutation forcée, c'est-à-dire celles où l'interrupteur est ouvert alors que le courant le traverse.

Dans un mode de réalisation, N vaut deux.

Ainsi, la réalisation peut être utilisée en tant que pont en H, c'est-à-dire une application dans laquelle une phase d'un récepteur électrique est alimentée, en opposition de phase, par deux bras d'onduleurs, par opposition avec une application où chaque phase est raccordée, d'une part, à un bras d'onduleur et, d'autre part, à un point commun à toutes les phases du récepteur électrique, appelé Neutre. L'avantage principal du pont en H est de permettre d'appliquer à la phase une gamme de tension moyenne comprise entre $+V_{DCBUS}$ et $-V_{DCBUS}$ lorsque la tension continue d'alimentation de l'onduleur vaut $V_{DCBUS}$ alors que dans une application avec point neutre, la gamme de tension moyenne n'est comprise qu'entre $+1/2\ V_{DCBUS}$ et $-1/2\ V_{DCBUS}$. Le prix à payer étant de doubler le nombre de bras d'onduleur entre une application pont en H et une application avec Neutre.

Par exemple, ledit convertisseur est un onduleur ou un hacheur.

Selon un autre aspect de l'invention, il est également proposé un système de commande d'au moins un vérin électrique d'un lanceur spatial comprenant au moins un convertisseur de puissance à découpage selon l'une des revendications précédentes, le récepteur électrique étant un moteur électrique et le convertisseur de puissance étant un onduleur.

Ainsi, le système de commande permet une modulation fine de la puissance appliquée au vérin. D'autre part, l'onduleur étant réversible, il permet de renvoyer vers la batterie l'énergie qui est extraite du vérin au lieu de la perdre, comme dans un système hydraulique à huile perdue utilisé actuellement sur les étages inférieurs d'Ariane 5.

Selon un autre aspect de l'invention, il est également proposé un lanceur spatial muni d'un système tel que précédemment décrit.

Ainsi, un tel système permet de libérer l'opérateur du lanceur des contraintes d'exploitation générées par les mesures de sécurité à mettre en oeuvre lors de l'utilisation de systèmes hydrauliques à huile perdue dans lesquels la source d'énergie est constituée par de grands réservoirs d'huile mis sous haute pression par de l'air comprimé à 200 bars. De plus, un tel système peut être alimenté à partir de batteries thermiques qui, ayant la particularité d'être inertes tant qu'elles ne sont pas activées, permettent à l'opérateur du lanceur de se libérer également des contraintes d'exploitation liées à l'utilisation d'accumulateurs électriques.

Selon un autre aspect de l'invention, il est également proposé un système de commande d'au moins un dispositif d'orientation d'antennes ou de panneaux solaires d'un satellite comprenant au moins un convertisseur de puissance à découpage tel que précédemment décrit, le récepteur électrique étant un moteur électrique et le convertisseur de puissance étant un onduleur.

Ainsi, les niveaux de surtension aux bornes du convertisseur peuvent être limités par rapport à celles induites par les autres systèmes, permettant un plus juste dimensionnement du système.

Selon un autre aspect de l'invention, il est également proposé un satellite muni d'un système de commande tel que précédemment décrit.

Selon un autre aspect de l'invention, il est également proposé un système d'alimentation d'un satellite comprenant au moins un convertisseur de puissance à découpage tel que décrit précédemment, le récepteur électrique étant un transformateur polyphasé et le convertisseur de puissance étant un onduleur ou hacheur.

Ainsi, les niveaux de surtension aux bornes du convertisseur peuvent être limités par rapport à ceux induits par les autres systèmes, permettant un plus juste dimensionnement du système.

Selon un autre aspect de l'invention, il est également proposé un satellite muni d'un système d'alimentation tel que précédemment décrit.

Plus généralement, la présente invention peut s'appliquer à toute application où la maîtrise des surtensions est requise, même une station orbitale. Le document WO 2015 008333 A1 divulgue un convertisseur de puissance comprenant des bras qui comportent dans chaque bras un interrupteur et deux diodes en parallèle entre eux et en série avec l'interrupteur. Les documents US 2009 285004 A1 et US 2015 340962 divulguent des convertisseurs de puissance avec redondance comprenant plusieurs interrupteurs et/ou diodes en série au lieu d'un interrupteur ou une diode. Le document US 2015 023084 divulgue une connexion spatiale des éléments d'un convertisseur afin d'améliorer le dimensionnement thermique du convertisseur.

L'invention sera mieux comprise à l'étude de quelques modes de réalisation décrits à titre d'exemples nullement limitatifs et illustrés par les dessins annexés sur lesquels :

- les figures 1a et 1b illustrent schématiquement les cinq périodes de la tension électrique dans le fonctionnement d'un pont en H d'onduleur pour un courant électrique de phase positif d'un récepteur électrique;

- les figures 2a et 2b illustrent schématiquement les trois périodes de la tension électrique dans le fonctionnement d'un pont en H d'onduleur pour un courant électrique de phase négatif d'un récepteur électrique;

- les figures 3a et 3b illustrent schématiquement les sept périodes de la tension électrique dans le fonctionnement d'un onduleur pour un récepteur électrique à trois phase et point neutre;

- les figures 4a, 4b, 4c et 4d représentent un demi-bras d'un convertisseur de puissance à découpage, lorsque N=2, selon divers aspects de l'invention;

- les figures 5a, 5b, représentent un bras d'un convertisseur de puissance à découpage avec N=2 et la figure 5c représente un bloc de deux bras, pouvant par exemple être utilisé comme pont en H ou comme double bras d'un convertisseur de puissance à découpage, lorsque N=2, selon des aspects de l'invention;

- les figures 6a et 6b représentent des exemples de réalisation d'un bloc de deux bras muni d'un bras additionnel pour un nombre total de bras impair, selon divers aspects de l'invention;

- les figures 7a et 7b illustrent les circulations des courants électriques dans un bloc de deux bras utilisé comme pont en H pour une phase de récepteur électrique respectivement pour un courant électrique positif et un courant électrique négatif;

- la figure 8a illustre le cas d'un nombre de phases impair, en l'occurrence trois phases et un neutre du récepteur électrique; et

- les figures 8b et 8c illustrent les circulations des courants électriques dans un bloc des figures 6a et 6b avec un récepteur électrique à trois phases et neutre.

Sur les différentes figures, les éléments ayant des références identiques sont identiques. Dans les exemples qui suivent, N vaut 2, mais bien entendu les exemples décrits s'appliquent en variante à toute valeur de N.

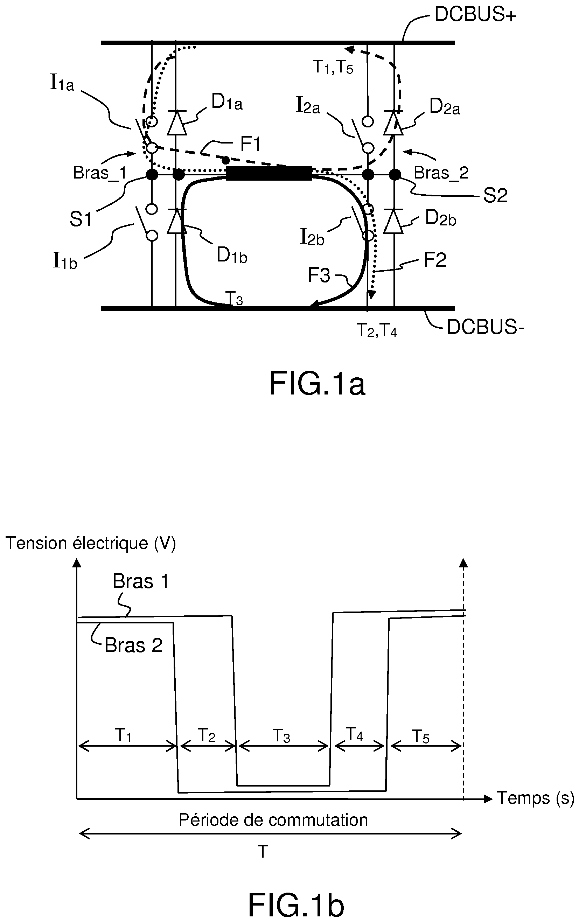

Les figures 1a et 1b représentent les cinq périodes de la tension électrique dans le fonctionnement d'un pont en H d'onduleur pour un courant électrique de phase positif d'un récepteur électrique. On appelle courant électrique de phase positif un courant entrant par la borne Active de la phase, repérée par un gros point sur les figures, et sortant par la borne Retour de la phase. La dénomination Active et Retour des bornes de la phase est déterminée par le fabricant du récepteur électrique en fonction du sens du champ magnétique développé par la phase au sein du récepteur électrique.

La figure 1a représente un pont en H d'onduleur commandant une phase Phase d'un récepteur électrique tel un moteur électrique comprenant une alimentation électrique positive DCBUS+ et une alimentation électrique négative DCBUS-, et les deux bras du pont en H, Bras_1 et Bras_2.

Le premier bras Bras_1 du pont en H comprend deux interrupteurs $I_{1a}$, $I_{1b}$ et deux diodes $D_{1a}$, $D_{1b}$, et le deuxième bras Bras_2 du pont en H comprend deux interrupteurs $I_{2a}$, $I_{2b}$ et deux diodes $D_{2a}$, $D_{2b}$.

La figure 1b représente cinq délais successifs $T_1$, $T_2$, $T_3$, $T_4$ et $T_5$ d'une période de commutation d'un courant électrique de phase positif dans le pont en H, pour les tensions électriques mesurées respectivement aux points S1 et S2 par rapport à la ligne d'alimentation DCBUS- des deux bras Bras_1, Bras_2.

Les délais $T_1$ et $T_5$ correspondent aux cas des interrupteurs $I_{1a}$ du premier bras Bras_1 et $I_{2a}$ du deuxième bras Bras_2 fermés ou actifs, dans lesquels le courant électrique de phase est rebouclé à travers la ligne positive d'alimentation DCBUS+; ces délais correspondent à une "roue libre" positive, comme illustré par la flèche F1, en trait de tirets.

On entend par "roue libre" ce qui suit. Si on souhaite faire passer un certain niveau de courant électrique dans une inductance ou self à partir d'une source de tension électrique, le meilleur moyen est de prendre un interrupteur et de délivrer à l'inductance des impulsions de tension régulières dont la valeur, en volts, et la durée, en secondes, font augmenter le courant électrique dans l'inductance suivant la loi $\frac{di}{dt} = \frac{e}{L}$ dans laquelle i représente l'intensité du courant électrique en ampères, L représente l'inductance en henry, et e représente la force électromotrice, en volts. L'ennui, avec une inductance, est que le courant électrique ne peut être interrompu brusquement; en effet, suivant la même loi, annuler rapidement un courant électrique existant demande de développer aux bornes de l'inductance une tension infinie. D'autre part, une inductance parcourue par un courant électrique i contient une énergie stockée W=1/2 Li² ; tant que le courant électrique circule, cette énergie reste stockée dans l'inductance, y compris si on la court-circuite; par contre, si un circuit externe la force à développer de la tension électrique, son énergie décroît. Aussi, pour alimenter une inductance, est-il nécessaire d'alterner les périodes d'alimentation de l'inductance avec des périodes dites de "roue libre", pendant lesquelles le courant électrique qui circulait précédemment dans l'inductance est maintenu par un circuit extérieur, sous une tension la plus faible possible, de façon à conserver l'énergie dans l'inductance.

La "roue libre", un peu comme dans le cas d'un vélo, est une période pendant laquelle le courant électrique circule sans entraîner d'augmentation ou de diminution notable de l'énergie stockée dans l'inductance.

Les délais $T_2$ et $T_4$ correspondent aux cas des interrupteurs $I_{1a}$ du premier bras Bras_1 et $I_{2b}$ du deuxième bras Bras_2 fermés ou actifs, dans lesquels le courant électrique de phase est dérivé de la ligne d'alimentation positive DCBUS+ vers la ligne d'alimentation négative DCBUS-; ces délais correspondent au transfert d'énergie, comme illustré par la flèche F2 en trait de pointillés.

Le délai $T_3$ correspond aux cas des interrupteurs $I_{1b}$ du premier bras Bras_1 et $I_{2b}$ du deuxième bras Bras_2 fermés ou actifs, dans lesquels le courant de phase est rebouclé à travers la ligne négative d'alimentation DCBUS-; ce délai correspond à une "roue libre" négative, comme illustré par la flèche F3 en trait plein ou continu.

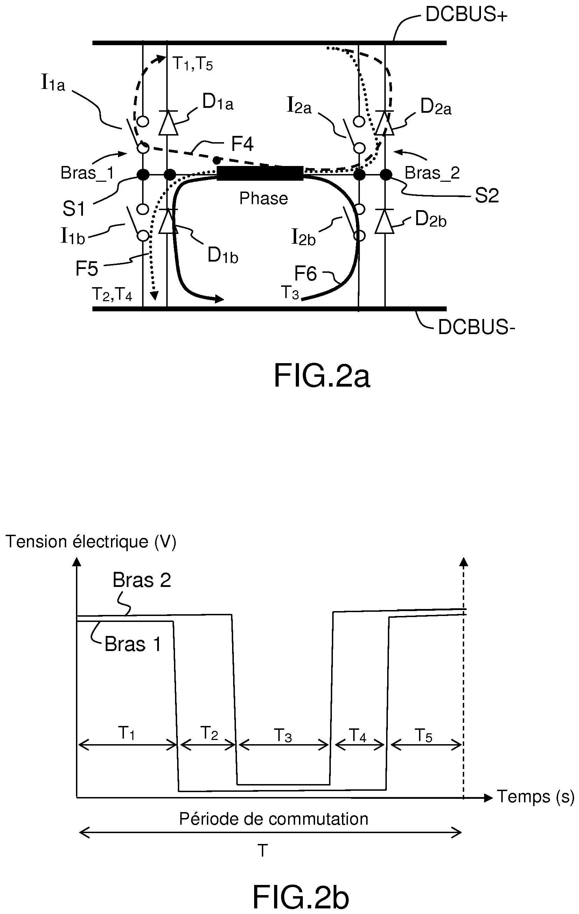

Les figures 2a et 2b représentent les cinq périodes de la tension électrique dans le fonctionnement d'un pont en H d'onduleur pour un courant électrique de phase négatif d'un récepteur électrique. On appelle courant électrique de phase négatif un courant entrant par la borne Retour de la phase et sortant par la borne Active de la phase, repérée par un point sur le schéma. La dénomination Active et Retour des bornes de la phase est déterminée par le fabricant du récepteur électrique en fonction du sens du champ magnétique développé par la phase au sein du récepteur électrique.

La figure 2a représente un pont en H d'onduleur commandant une phase Phase d'un récepteur électrique tel un moteur électrique comprenant une alimentation électrique positive DCBUS+ et une alimentation électrique négative DCBUS-, et les deux bras du pont en H, Bras1 et Bras2.

Le premier bras Bras_1 du pont en H comprend deux interrupteurs $I_{1a}$, $I_{1b}$ et deux diodes $D_{1a}$, $D_{1b}$, et le deuxième bras Bras_2 du pont en H comprend deux interrupteurs $I_{2a}$, $I_{2b}$ et deux diodes $D_{2a}$, $D_{2b}$.

La figure 2b représente cinq délais successifs $T_1$, $T_2$, $T_3$, $T_4$ et $T_5$ d'une période de commutation d'un courant électrique de phase négatif dans le pont en H, pour les tensions électriques mesurées respectivement aux points S1 et S2 par rapport à la ligne d'alimentation DCBUS- des deux bras Bras_1, Bras_2.

Les délais $T_1$ et $T_5$ correspondent aux cas des interrupteurs $I_{1a}$ du premier bras Bras_1 et $I_{2a}$ du deuxième bras Bras_2 fermés ou actifs, dans lesquels le courant électrique de phase est rebouclé à travers la ligne positive d'alimentation DCBUS+; ces délais correspondent à une "roue libre" positive, comme illustré par la flèche F4 en trait de tirets.

Les délais $T_2$ et $T_4$ correspondent aux cas des interrupteurs $I_{1a}$ du premier bras Bras_1 et $I_{2a}$ du deuxième bras Bras_2 fermés ou actifs, dans lesquels le courant électrique de phase est dérivé de la ligne d'alimentation positive DCBUS+ vers la ligne d'alimentation négative DCBUS-; ces délais correspondent au transfert d'énergie, comme illustré par la flèche F5 en trait de pointillés.

Le délai $T_3$ correspond aux cas des interrupteurs $I_{1b}$ du premier bras Bras_1 et $I_{2b}$ du deuxième bras Bras_2 fermés ou actifs, dans lesquels le courant électrique de phase est rebouclé à travers la ligne négative d'alimentation DCBUS-; ce délai correspond à une "roue libre" négative, comme illustré par la flèche F6 en trait plein ou continu.

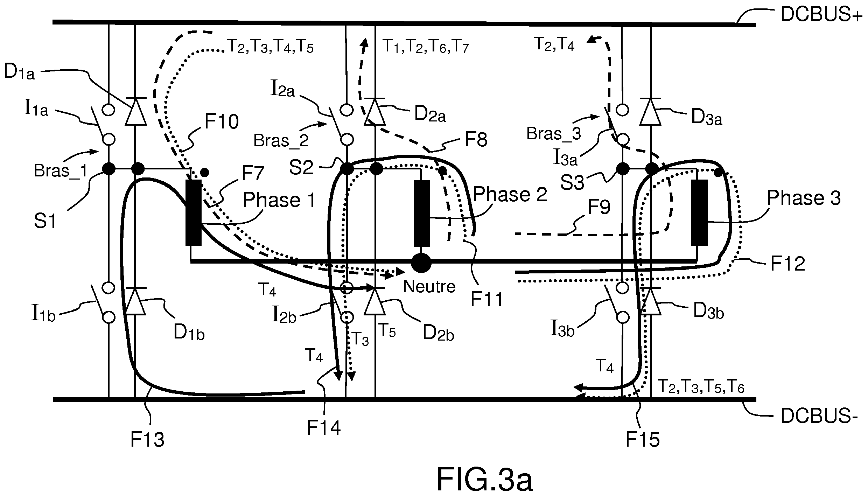

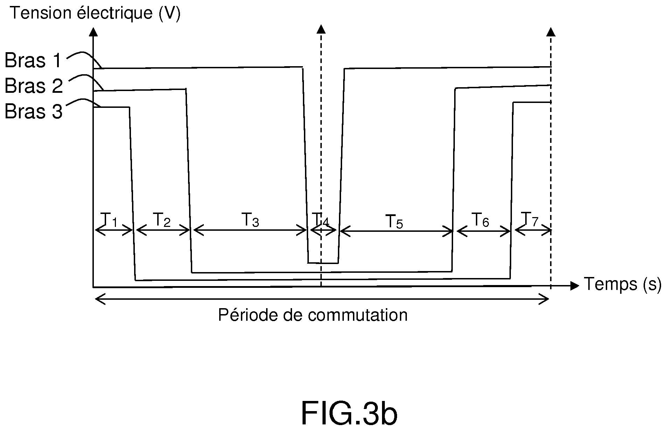

Les figures 3a et 3b représentent les sept périodes de la tension électrique dans le fonctionnement d'un onduleur à trois bras pour un récepteur électrique tel un moteur électrique à trois phases Phase1, Phase2, Phase3, et point neutre Neutre.

La figure 3a représente un onduleur à trois bras Bras_1, Bras_2 et Bras_3 comprenant une alimentation électrique positive DCBUS+ et une alimentation électrique négative DCBUS-.

Le premier bras Bras_1 de l'onduleur comprend deux interrupteurs $I_{1a}$, $I_{1b}$ et deux diodes $D_{1a}$, $D_{1b}$, le deuxième bras Bras_2 du pont en H comprend deux interrupteurs $I_{2a}$, $I_{2b}$ et deux diodes $D_{2a}$, $D_{2b}$, et le troisième bras Bras_3 comprend deux interrupteurs $I_{3a}$, $I_{3b}$ et deux diodes $D_{3a}$, $D_{3b}$.

La figure 3b représente sept délais successifs $T_1$, $T_2$, $T_3$, $T_4$, $T_5$, $T_6$, et $T_7$ d'une période de commutation d'un courant électrique de phase positif dans l'onduleur, pour les tensions électriques mesurées respectivement aux points S1, S2 et S3 par rapport à la ligne d'alimentation DCBUS- des trois bras Bras_1, Bras_2, et Bras_3.

Le fonctionnement d'un onduleur à M phases se décompose en 2M+1 périodes, en l'espèce dans le cas décrit le fonctionnement d'un onduleur à trois phases se décomposant en sept périodes ou sept délais successifs $T_1$, $T_2$, $T_3$, $T_4$, $T_5$, $T_6$, et $T_7$.

La figure 3b ci-dessous montre le fonctionnement d'un onduleur triphasé Phase1, Phase2, Phase3 à trois bras Bras_1, Bras_2, et Bras_3 qui comporte sept périodes de fonctionnement $T_1$, $T_2$, $T_3$, $T_4$, $T_5$, $T_6$, et $T_7$ (pour les besoins de l'explication, son fonctionnement est figé à +15°, ce qui entraine une répartition des courants électriques suivant les proportions respectives de +97%, -70% et -27% dans son repère triphasé cosinusoïdal).

Les délais $T_1$ et $T_7$ correspondent aux cas des interrupteurs $I_{1a}$ du premier bras Bras_1, $I_{2a}$ du deuxième bras Bras_2 et $I_{3a}$ du troisième bras Bras_3 fermés ou actifs, dans lesquels les courants électriques de phase sont rebouclés à travers la ligne positive d'alimentation DCBUS+, ce temps correspond à une "roue libre" positive comme illustré par les flèches F7, F8, et F9.

Les délais $T_2$ et $T_6$ correspondent aux cas des interrupteurs $I_{1a}$ du premier bras Bras_1, $I_{2a}$ du deuxième bras Bras_2, et $I_{3b}$ du troisième bras Bras_3 fermés ou actifs, dans lesquels le courant électriques de la phase Phase3 est dérivé de l'alimentation DCBUS+, c'est une durée pendant laquelle le transfert d'énergie est opéré tandis que le courant électrique de la phase Phase2 est encore en "roue libre" positive; le courant électrique de la phase Phase1 est la somme des deux autres courants comme illustré par les flèches F10, F8, et F12.

Les délais $T_3$ et $T_5$ correspondent aux cas des interrupteurs $I_{1a}$ du premier bras Bras_1, $I_{2b}$ du deuxième bras Bras_2, et $I_{3b}$ du troisième bras Bras_3 fermés ou actifs, dans lesquels les courants électriques des phases Phase2 et Phase3 sont dérivé de l'alimentation DCBUS+, c'est une durée pendant laquelle le transfert d'énergie est opéré; le courant électrique de la phase Phase1 est la somme des deux autres courants électriques, comme illustré par les flèches F10, F11, et F12.

Le délai $T_4$ correspond au cas des interrupteurs $I_{1b}$ du premier bras Bras_1, $I_{2b}$ du deuxième bras Bras_2, et $I_{3b}$ du troisième bras Bras_3 fermés ou actifs, dans lequel les courants électriques de phase des phases Phase1, Phase2, Phase3 sont rebouclés à travers la ligne négative d'alimentation DCBUS-, ce délai correspond à une "roue libre" négative, comme illustré par les flèches F13, F14, et F15.

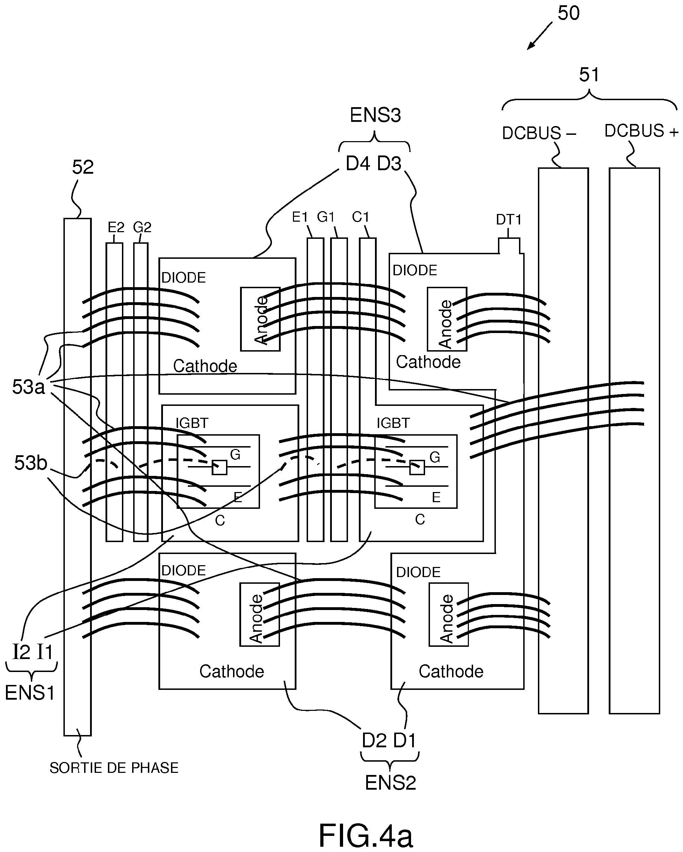

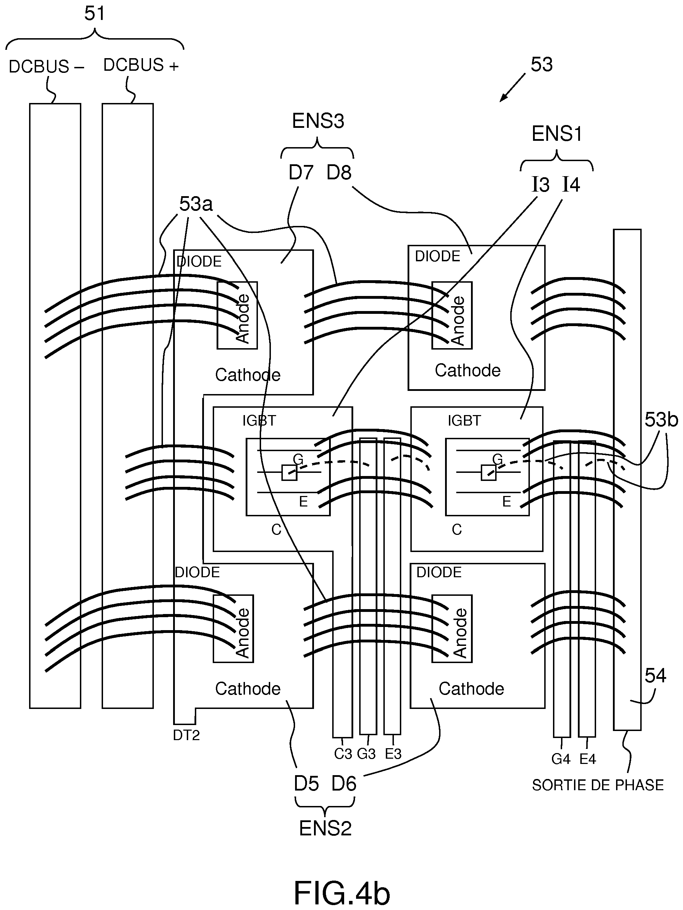

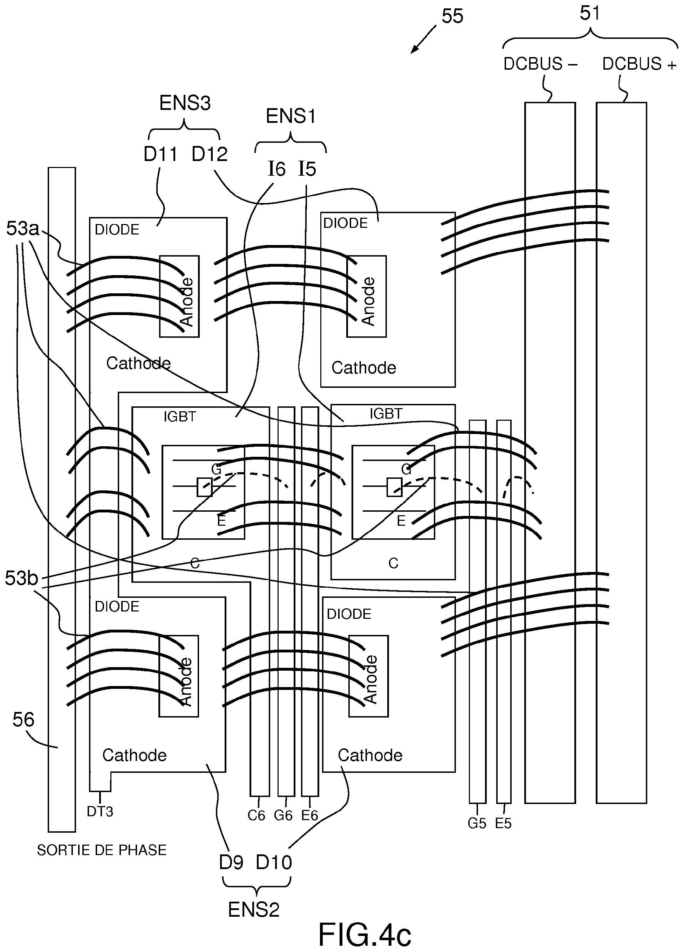

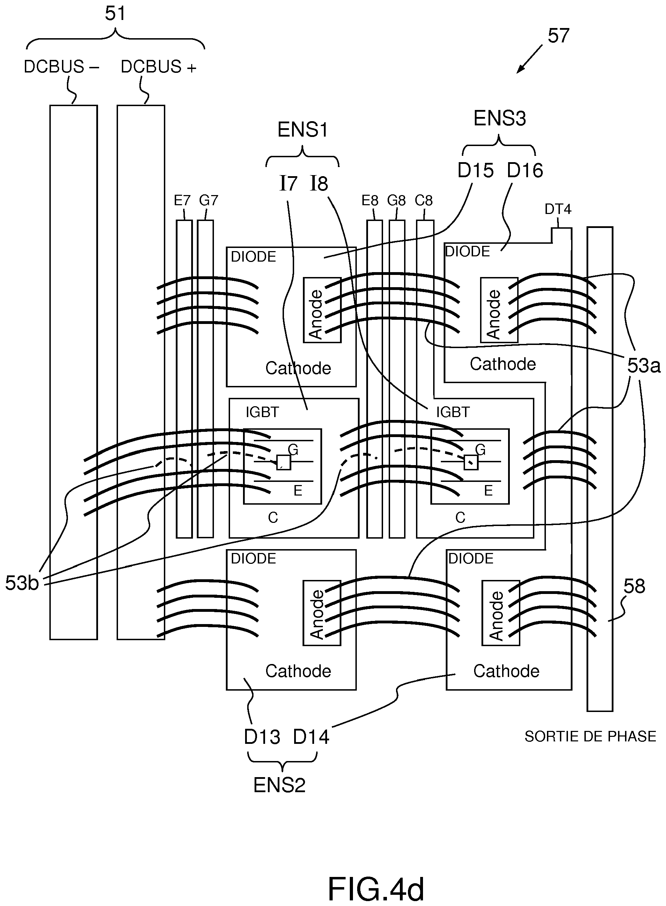

Les figures 4a, 4b, 4c et 4d illustrent un demi-bras d'un convertisseur de puissance à découpage, lorsque N=2, comme un onduleur, un hacheur, ou un gradateur, configuré pour commander au moins une phase d'un récepteur électrique polyphasé à au moins trois phases, tel un moteur électrique ou un transformateur, comprenant au moins deux bras de convertisseur, selon divers aspects de l'invention.

Les interrupteurs peuvent comprendre au moins un transistor bipolaire à grille isolée ou IGBT pour acronyme de "Insulated Gate Bipolar Transistor" en langue anglaise et/ou au moins un transistor à effet de champ à grille isolée ou MOSFET pour acronyme de "Metal Oxide Semiconductor Field Effect Transistor" en langue anglaise. Dans les exemples décrits, les interrupteurs sont des transistors bipolaires à grille isolée ou IGBT, de manière non limitative.

La figure 4a représente un demi-bras 50 d'un convertisseur de puissance à découpage, lorsque N=2, pour une utilisation positive, i.e. connectée à une ligne positive d'alimentation DCBUS+, dans une implantation à gauche.

Un tel demi-bras 50 d'un bras de convertisseur de puissance à découpage comprend un premier ensemble ENS1 de N interrupteurs (N ≥ 2), en l'espèce deux interrupteurs I1, I2, disposés en série, et 2N diodes de puissance, en l'espèce quatre diodes D1, D2, D3, et D4 disposées N à N, en l'espèce deux à deux, en série et en parallèle, formant des deuxième et troisième ensembles ENS2, ENS3 de deux diodes comprenant chacun deux diodes en série D1, D2, et D3, D4, les deuxième et troisième ensembles ENS2, ENS3 étant montés en parallèle entre-eux et en série avec les deux interrupteurs en série I1, I2, le premier ensemble ENS1 de deux interrupteurs en série, I1, I2 étant disposé entre les deuxième et troisième ensembles ENS2 et ENS3 de deux diodes en série D1, D2, et D3, D4.

Le convertisseur de puissance à découpage comprend une alimentation électrique coplanaire 51, munie d'une ligne positive DCBUS+ et d'une ligne négative DCBUS-, disposée de manière à séparer deux bras du convertisseur, et comprenant une interface de puissance par bras, comme une barre omnibus ou barre de distribution pour "busbar" en langue anglaise. Chaque interface de puissance est disposée de sorte que les deux demi-bras du bras correspondant soient situés entre l'alimentation électrique coplanaire 51 et l'interface de puissance correspondante. Les différentes connexions sont représentées par des fils de connexion 53a, et représentées par des fils de connexion bas niveau 53b. Dans la présente implantation d'un demi-bras à gauche est représentée l'interface de puissance 52.

Les connexions d'émetteur E1, E2 des interrupteurs I1, I2 correspondants, sont utilisées comme retour de la commande des interrupteurs I1, I2.

Les connexions G1, G2 de grille des interrupteurs transistors I1, I2 sont utilisées pour la commande des interrupteurs I1, I2.

La connexion C1 de collecteur de l'interrupteur transistor I1 peut servir à de l'autotest.

Le point milieu DT1 de la mise en série des diodes peut servir à de l'autotest.

La figure 4b représente un demi-bras 53 d'un convertisseur de puissance à découpage, lorsque N=2, pour une utilisation positive, i.e. connectée à une ligne positive d'alimentation, dans une implantation à droite.

Un tel demi-bras 53 d'un bras de convertisseur de puissance à découpage comprend un premier ensemble ENS1 de N interrupteurs (N ≥ 2), en l'espèce deux interrupteurs I3, I4, disposés en série, et 2N diodes de puissance, en l'espèce quatre diodes D5, D6, D7, et D8 disposées N à N, en l'espèce deux à deux, en série et en parallèle, formant des deuxième et troisième ensembles ENS2, ENS3 de deux diodes comprenant chacun deux diodes en série D5, D6, et D7, D8, les deuxième et troisième ensembles ENS2, ENS3 étant montés en parallèle entre-eux et en série avec les deux interrupteurs en série I3, I4, le premier ensemble ENS1 de deux interrupteurs en série I3, I4 étant disposé entre les deuxième et troisième ensembles ENS2 et ENS3 de deux diodes en série D5, D6, et D7, D8.

Dans la présente implantation d'un demi-bras à droite est représentée l'interface de puissance 54.

Les connexions d'émetteur E3, E4 des interrupteurs I3, I4 correspondants, sont utilisées comme retour de la commande des interrupteurs I3, I4.

Les connexions G3, G4 de grille des interrupteurs transistors I3, I3 sont utilisées pour la commande des interrupteurs I3, I4.

La connexion C3 de collecteur de l'interrupteur transistor I3 peut servir à de l'autotest.

Le point milieu DT2 de la mise en série des diodes peut servir à de l'autotest.

La figure 4c représente un demi-bras 55 d'un convertisseur de puissance à découpage, lorsque N=2, pour une utilisation négative, i.e. connectée à une ligne négative d'alimentation DCBUS-, dans une implantation à gauche.

Un tel demi-bras 55 d'un bras de convertisseur de puissance à découpage comprend un premier ensemble ENS1 de N interrupteurs (N ≥ 2), en l'espèce deux interrupteurs I5, I6, disposés en série, et 2N diodes de puissance, en l'espèce quatre diodes D9, D10, D11, et D12 disposées N à N, en l'espèce deux à deux, en série et en parallèle, formant des deuxième et troisième ensembles ENS2, ENS3 de deux diodes comprenant chacun deux diodes en série D9, D10, et D11, D12, les deuxième et troisième ensembles ENS2, ENS3 étant montés en parallèle entre-eux et en série avec les deux interrupteurs en série I5, I6, le premier ensemble ENS1 de deux interrupteurs en série I5, I6 étant disposé entre les deuxième et troisième ensembles ENS2 et ENS3 de deux diodes en série D9, D10, et D11, D12.

Dans la présente implantation d'un demi-bras à gauche est représentée l'interface de puissance 56.

Les connexions d'émetteur E5, E6 des interrupteurs I5, I6 correspondants, sont utilisées comme retour de la commande des interrupteurs I5, I6.

Les connexions G5, G6 de grille des interrupteurs transistors I5, I6 sont utilisées pour la commande des interrupteurs I5, I6.

La connexion C5 de collecteur de l'interrupteur transistor I5 peut servir à de l'autotest.

Le point milieu DT3 de la mise en série des diodes peut servir à de l'autotest.

La figure 4d représente un demi-bras 57 d'un convertisseur de puissance à découpage, lorsque N=2, pour une utilisation négative, i.e. connectée à une ligne négative d'alimentation, dans une implantation à droite.

Un tel demi-bras 57 d'un bras de convertisseur de puissance à découpage comprend un premier ensemble ENS1 de N interrupteurs (N ≥ 2), en l'espèce deux interrupteurs I7, I8, disposés en série, et 2N diodes de puissance, en l'espèce quatre diodes D13, D14, D15, et D16 disposées N à N, en l'espèce deux à deux, en série et en parallèle, formant des deuxième et troisième ensembles ENS2, ENS3 de deux diodes comprenant chacun deux diodes en série D13 D14, et D15, D16, les deuxième et troisième ensembles ENS2, ENS3 étant montés en parallèle entre-eux et en série avec les deux interrupteurs en série I7, I8, le premier ensemble ENS1 de deux interrupteurs en série I7, I8 étant disposé entre les deuxième et troisième ensembles ENS2 et ENS3 de deux diodes en série D13 D14, et D15, D16.

Dans la présente implantation d'un demi-bras à droite est représentée l'interface de puissance 58.

Les connexions d'émetteur E7, E8 des interrupteurs I7, I8 correspondants, sont utilisées comme retour de la commande des interrupteurs I7, I8.

Les connexions G7, G8 de grille des interrupteurs transistors I7, I8 sont utilisées pour la commande des interrupteurs I7, I8.

La connexion C8 de collecteur de l'interrupteur transistor I8 peut servir à de l'autotest.

Le point milieu DT4 de la mise en série des diodes peut servir à de l'autotest.

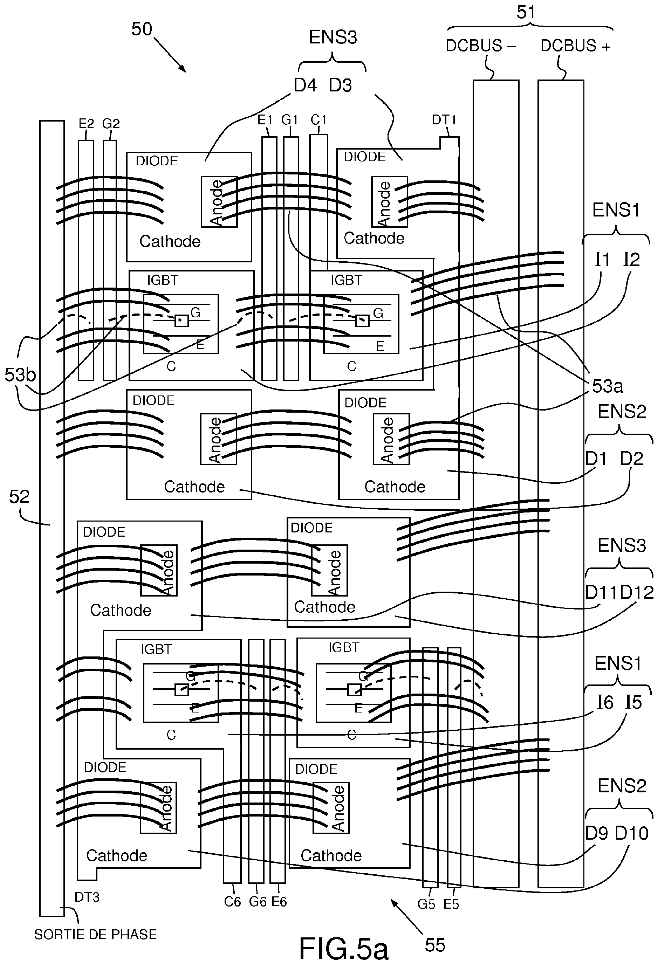

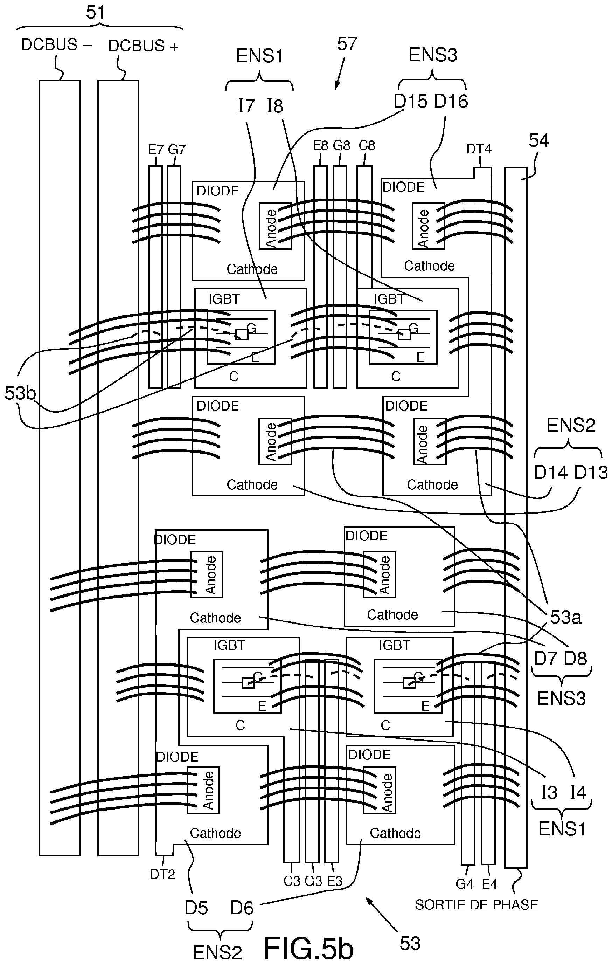

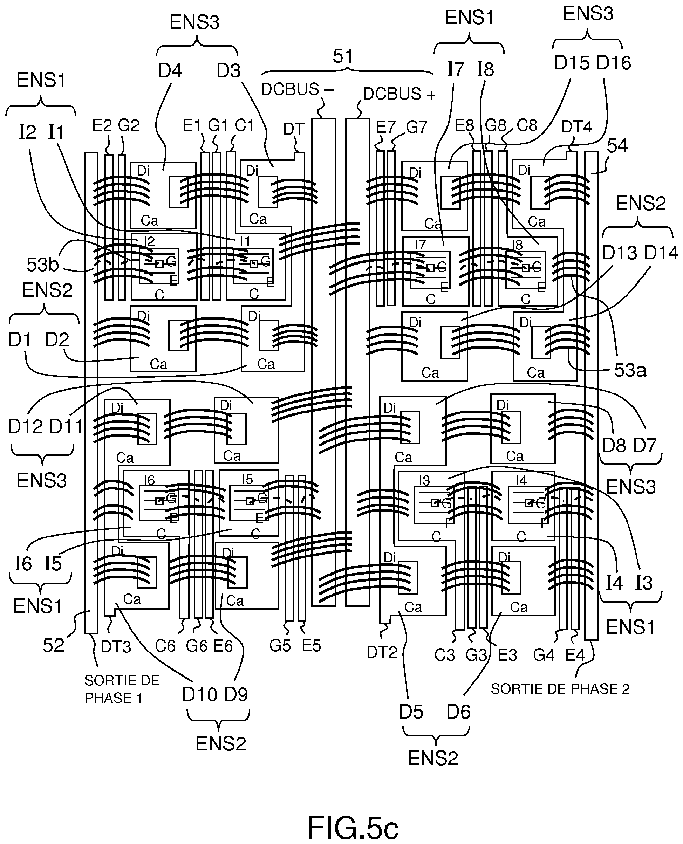

Les figures 5a, 5b, représentent un bras d'un convertisseur de puissance à découpage avec N=2 et la figure 5c représente un bloc de deux bras, pouvant par exemple être utilisé comme pont en H ou comme double bras d'un convertisseur de puissance à découpage, lorsque N=2, selon un aspect de l'invention.

La figure 5a représente un bras d'un convertisseur de puissance à découpage avec N=2 à implantation à gauche est composée de deux demi-bras, l'un selon la figure 4a et l'autre selon la figure 4c. L'interface de puissance 52 est la même que l'interface de puissance 56.

La figure 5b représente un bras d'un convertisseur de puissance à découpage avec N=2 à implantation à droite est composée de deux demi-bras, l'un selon la figure 4b et l'autre selon la figure 4d. L'interface de puissance 54 est la même que l'interface de puissance 58.

La figure 5c représente un bloc 60 de deux bras, étant la combinaison d'un bras implanté à gauche selon la figure 5a et d'un bras implanté à droite selon la figure 5b, pouvant par exemple être utilisé comme pont en H ou comme double bras d'un convertisseur de puissance à découpage, lorsque N=2, selon un aspect de l'invention. Bien entendu tous ces modes de réalisation ne sont pas limitatifs, car ils peuvent être adaptés à différentes géométries.

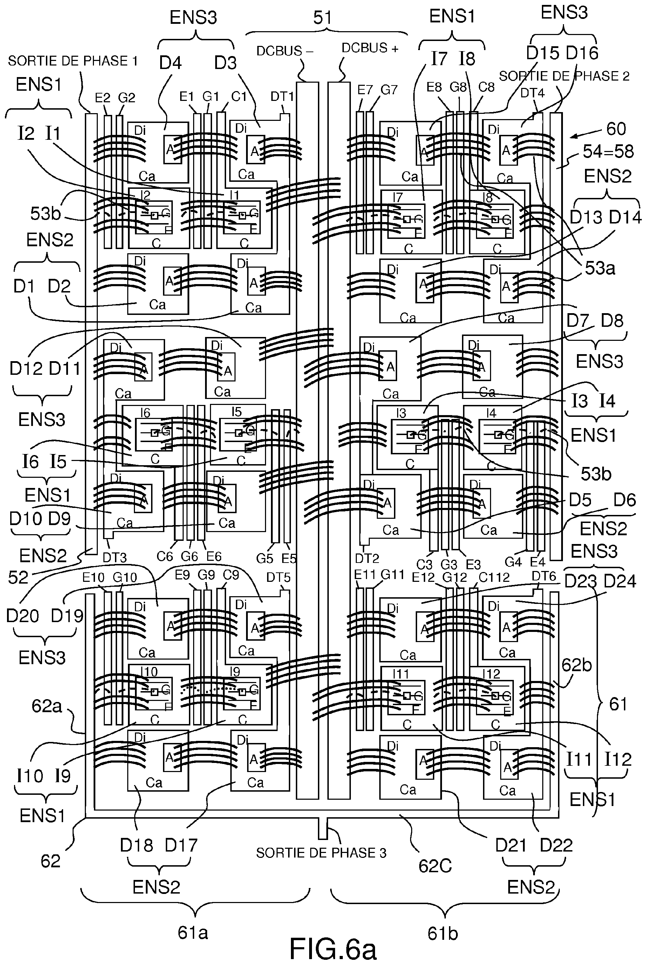

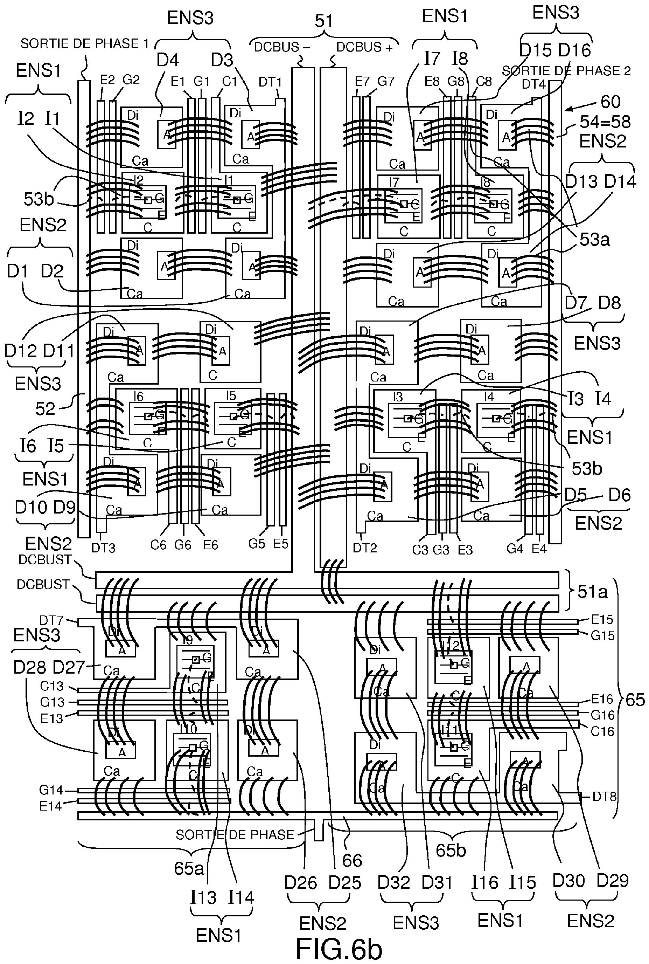

Les figures 6a et 6b représentent des exemples de réalisation d'un bloc 60 de deux bras selon la figure 5c, muni d'un bras additionnel pour un nombre total de bras impair, selon deux modes de réalisation non limitatifs.

Le mode de réalisation de la figure 6a représente un bloc 60 de deux bras, selon la figure 5c, muni d'un bras additionnel 61 comprenant deux demi-bras 61a, 61b disposés de part et d'autre de l'alimentation électrique coplanaire 51 prolongée. Sur le mode de réalisation, le bras additionnel 61 comprend un demi-bras positif avec implantation à gauche 61a et un demi-bras négatif avec implantation à droite 61b. Le bras additionnel 61 comprend en outre une interface de puissance 62 comprenant respectivement, pour chacun des deux demi-bras 61a, 61b, une partie 62a, 62b disposée de sorte que le demi-bras correspondant 61a, 61b est situé entre l'alimentation électrique coplanaire 51 et la partie de l'interface de puissance correspondante, ou, en d'autre termes la prolongation de l'interface de puissance 51. En l'espèce, l'interface de puissance 62 du bras additionnel 61, comprend donc trois parties 62a, 62b et 62c formant un U.

Le demi-bras 61a du bras additionnel 61 comprend un premier ensemble ENS1 de N interrupteurs (N ≥ 2), en l'espèce deux interrupteurs I9, I10, disposés en série, et 2N diodes de puissance, en l'espèce quatre diodes D17, D18, D19, et D20 disposées N à N, en l'espèce deux à deux, en série et en parallèle, formant des deuxième et troisième ensembles ENS2, ENS3 de deux diodes comprenant chacun deux diodes en série D17 D18, et D19, D20, les deuxième et troisième ensembles ENS2, ENS3 étant montés en parallèle entre-eux et en série avec les deux interrupteurs en série I9, I10, le premier ensemble ENS1 de deux interrupteurs en série I9, I10 étant disposé entre les deuxième et troisième ensembles ENS2 et ENS3 de deux diodes en série D17 D18, et D19, D20.

Les connexions d'émetteur E9, E10 des interrupteurs I9, I10 correspondants, sont utilisées comme retour de la commande des interrupteurs I9, I10.

Les connexions G9, G10 de grille des interrupteurs transistors I9, I10 sont utilisées pour la commande des interrupteurs I9, I10.

La connexion C9 de collecteur de l'interrupteur transistor I9 peut servir à de l'autotest.

Le point milieu DT5 de la mise en série des diodes peut servir à de l'autotest.

Le demi-bras 61b du bras additionnel 61 comprend un premier ensemble ENS1 de N interrupteurs (N ≥ 2), en l'espèce deux interrupteurs I11, I12, disposés en série, et 2N diodes de puissance, en l'espèce quatre diodes D21, D22, D23, et D24 disposées N à N, en l'espèce deux à deux, en série et en parallèle, formant des deuxième et troisième ensembles ENS2, ENS3 de deux diodes comprenant chacun deux diodes en série D21 D22, et D23, D24, les deuxième et troisième ensembles ENS2, ENS3 étant montés en parallèle entre-eux et en série avec les deux interrupteurs en série I11, I12, le premier ensemble ENS1 de deux interrupteurs en série I11, I12 étant disposé entre les deuxième et troisième ensembles ENS2 et ENS3 de deux diodes en série D21 D22, et D23, D24.

Les connexions d'émetteur E11, E12 des interrupteurs I11, I12 correspondants, sont utilisées comme retour de la commande des interrupteurs I11, I12.

Les connexions G11, G12 de grille des interrupteurs transistors I9, I10 sont utilisées pour la commande des interrupteurs I11, I12.

La connexion C12 de collecteur de l'interrupteur transistor I12 peut servir à de l'autotest.

Le point milieu DT6 de la mise en série des diodes peut servir à de l'autotest.

Le mode de réalisation de la figure 6b représente un bloc 60 de deux bras, selon la figure 5c, muni d'un bras additionnel 65. Le bloc 60 comprend en outre, une portion additionnelle 51a d'alimentation électrique coplanaire 51 disposée à une extrémité et dans une direction différente du reste de l'alimentation électrique coplanaire 51, et une interface de puissance 66 du bras additionnel 65 disposée de sorte que le bras additionnel 65 est situé entre ladite portion additionnelle 51a d'alimentation électrique coplanaire et ladite interface de puissance correspondante 66.

La portion additionnelle 51a d'alimentation électrique coplanaire peut avantageusement être sensiblement perpendiculaire au reste de l'alimentation électrique coplanaire 51.

Le demi-bras 65a du bras additionnel 65 comprend un premier ensemble ENS1 de N interrupteurs (N ≥ 2), en l'espèce deux interrupteurs I13, I14, disposés en série, et 2N diodes de puissance, en l'espèce quatre diodes D25, D26, D27, et D28 disposées N à N, en l'espèce deux à deux, en série et en parallèle, formant des deuxième et troisième ensembles ENS2, ENS3 de deux diodes comprenant chacun deux diodes en série D25 D26, et D27, D28, les deuxième et troisième ensembles ENS2, ENS3 étant montés en parallèle entre-eux et en série avec les deux interrupteurs en série I13, I14, le premier ensemble ENS1 de deux interrupteurs en série I13, I14 étant disposé entre les deuxième et troisième ensembles ENS2 et ENS3 de deux diodes en série D25 D26, et D27, D28.

Les connexions d'émetteur E15, E16 des interrupteurs I15, I16 correspondants, sont utilisées comme retour de la commande des interrupteurs I15, I16.

Les connexions G15, G16 de grille des interrupteurs transistors I13, I14 sont utilisées pour la commande des interrupteurs I15, I16.

La connexion C15 de collecteur de l'interrupteur transistor I15 peut servir à de l'autotest.

Le point milieu DT7 de la mise en série des diodes peut servir à de l'autotest.

Le demi-bras 65b du bras additionnel 65 comprend un premier ensemble ENS1 de N interrupteurs (N ≥ 2), en l'espèce deux interrupteurs I15, I16, disposés en série, et 2N diodes de puissance, en l'espèce quatre diodes D29, D30, D31, et D32 disposées N à N, en l'espèce deux à deux, en série et en parallèle, formant des deuxième et troisième ensembles ENS2, ENS3 de deux diodes comprenant chacun deux diodes en série D29 D30, et D31, D32, les deuxième et troisième ensembles ENS2, ENS3 étant montés en parallèle entre-eux et en série avec les deux interrupteurs en série I15, I16, le premier ensemble ENS1 de deux interrupteurs en série I15, I16 étant disposé entre les deuxième et troisième ensembles ENS2 et ENS3 de deux diodes en série D29 D30, et D31, D32.

Les connexions d'émetteur E13, E14 des interrupteurs I13, I14 correspondants, sont utilisées comme retour de la commande des interrupteurs I13, I14.

Les connexions G13, G14 de grille des interrupteurs transistors 113, 114 sont utilisées pour la commande des interrupteurs 113, 114.

La connexion C13 de collecteur de l'interrupteur transistor I13 peut servir à de l'autotest.

Le point milieu DT8 de la mise en série des diodes peut servir à de l'autotest.

En l'espèce, l'alimentation électrique coplanaire 51, 51a forme un T à l'envers.

En cours de commutation, lors des phases dites de "roue libre", les courants s'échangent entre les bras d'onduleur du pont en H à travers les lignes d'alimentation DCBUS+, DCBUS-. Suivant l'inductance parasite de ces lignes, des surtensions vont y être générées.

La présente invention propose de placer les bras d'onduleur dos à dos, de manière à ce que les échanges de courants entre les deux bras d'onduleur soient les plus directs possible, donc les moins inductifs possibles.

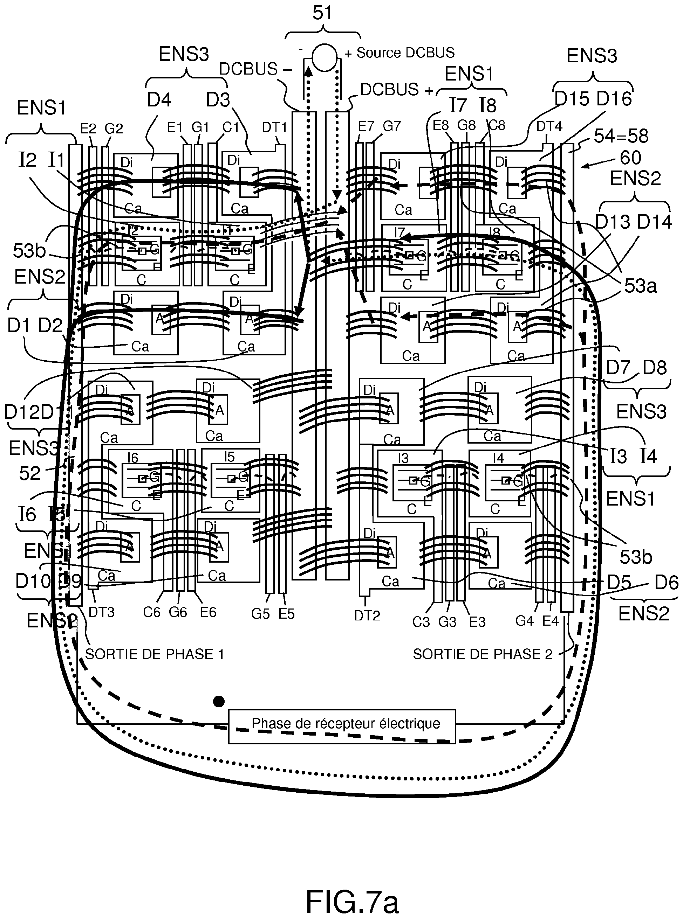

La figure 7a illustre les circulations des courants électriques dans un bloc 60 de deux bras utilisé comme pont en H pour une phase de récepteur électrique Phase, dans le cas d'un courant électrique de phase positif.

Pour la "roue libre" dans la barre d'alimentation positive, le courant suit le chemin indiqué par les flèches en traits de tirets.

Pour la "roue libre" dans la barre d'alimentation négative, le courant suit le chemin indiqué par les flèches en traits pleins ou continus.

Les flèches en traits de pointillés indiquent la circulation du courant, pendant la période active. Pendant cette période, le courant est issu de la source DCBUS sous la tension $V_{DCBUS}$, ce qui correspond à l'énergie délivrée par la source à la phase.

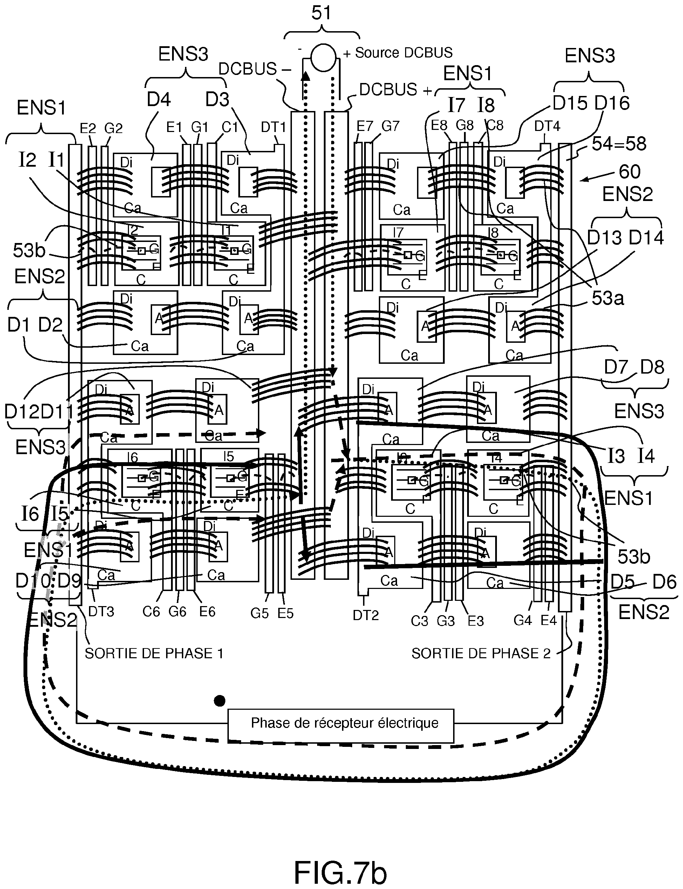

La figure 7b illustre les circulations des courants électriques dans un bloc 60 de deux bras utilisé comme pont en H pour une phase de récepteur électrique Phase, dans le cas d'un courant électrique de phase négatif.

Pour la "roue libre" dans la barre d'alimentation positive, le courant suit le chemin indiqué par les flèches en traits pointillés.

Pour la "roue libre" dans la barre d'alimentation négative, le courant suit le chemin indiqué par les flèches en traits pleins ou continus.

Les flèches en traits pointillés indiquent la circulation du courant, pendant la période active. Pendant cette période, le courant est issu de la source DCBUS sous la tension $V_{DCBUS}$, ce qui correspond à l'énergie délivrée par la source à la phase.

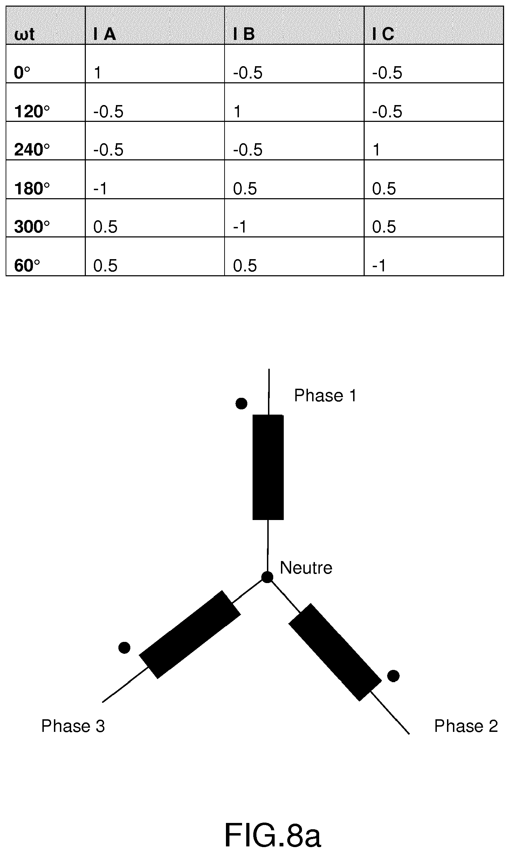

La figure 8a illustre le cas d'un nombre impair (2M+1) de phases du récepteur électrique, en l'occurrence trois phases Phase1, Phase2, Phase3 et un neutre du récepteur électrique.

Le récepteur électrique, par exemple le moteur électrique tournant sur 360°, chaque phase (prenons le cas du triphasé) est déphasée de 120° mais chaque phase voit un courant de type I= Io cos ($\omega$t+ $\theta$) où $\theta$ vaut respectivement 0, 120° et 240°.

On peut trouver des angles remarquables (tous les 60°) respectant le tableau de la figure 8a, il est donc possible d'étudier plus aisément la circulation des courants commutés pour les angles remarquables.

D'autre part, le raccordement est d'office avec un neutre Neutre comme représenté sur le dessin de la figure 8a.

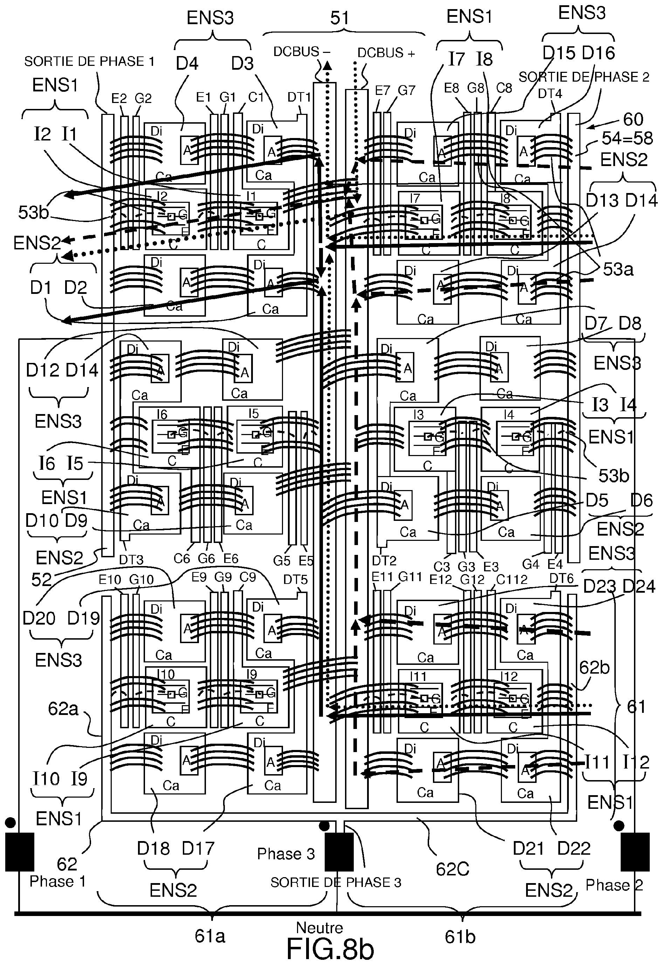

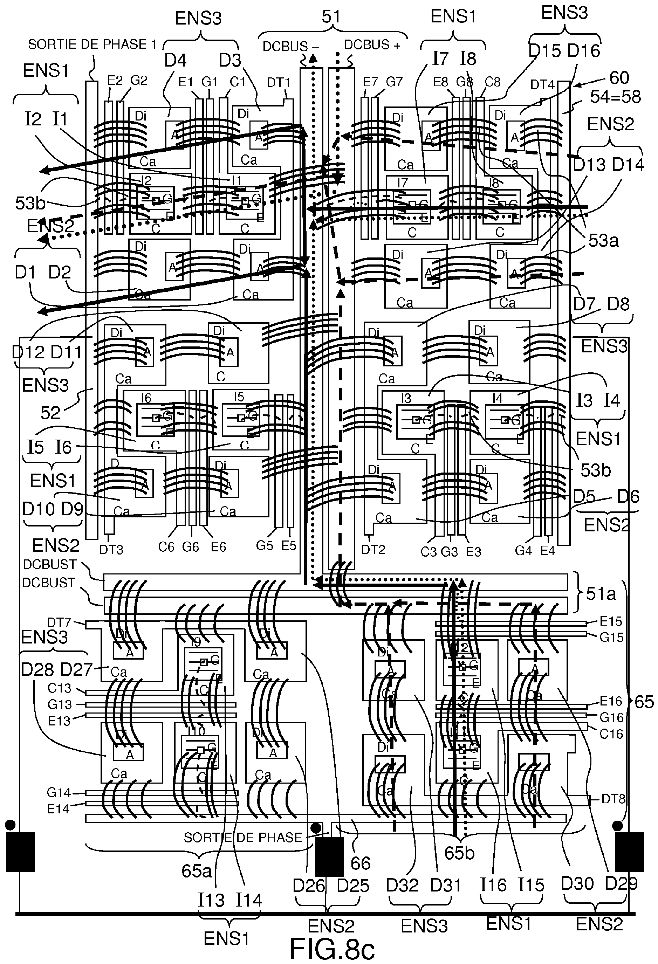

Les figures 8b et 8c illustrent les circulations des courants électriques dans un bloc des figures 6a et 6b avec un récepteur électrique à trois phases et neutre, dans le cas de l'angle remarquable 0° où les trois courants ont les proportions respectives : 1, -0.5, -0.5.

Au vu des deux figures 8a et 8b de circulation de courant, les courants électriques de commutation de la phase impaire reviennent à travers le busbar DCBUS (DCBUS+ et DCBUS-) ; si le busbar coplanaire est de bonne qualité, la self ou inductance est très faible puisque la différence de chemin entre les tracés en traits pleins ou continus, en traits pointillés et en traits de tirets est minime.

Par contre, on devine que le dessin T à l'envers de la figure 8c est préférable au dessin U de la figure 8b puisque la différence de chemin au moment où le courant change de sens (passe du demi-bras de droite à celui de gauche) sera plus petite.

Aussi, la présente invention répond à l'exigence de tolérance aux pannes, y compris celles des circuits de commande.

En réduisant à leurs minima les inductances parasites, la solution permet d'utiliser des composants mieux dimensionnés en tension électrique, ce qui entraîne moins de pertes Joules dans le convertisseur de puissance, donc un meilleur rendement et un dimensionnement thermique optimal.

En réduisant à leurs minima les inductances parasites, la présente invention permet de mieux exploiter la tension d'alimentation.

En favorisant la compacité de la solution, l'invention en réduit la masse, critère important dans le monde des lanceurs et des satellites.

**Revendications**

1. Convertisseur de puissance à découpage configuré pour commander au moins une phase d'un récepteur électrique polyphasé à au moins trois phases, comprenant au moins un bloc (60) de deux bras de convertisseur, dans lequel chaque demi-bras de bras de convertisseur comprend un premier ensemble (ENS1) de N interrupteurs, N étant supérieur ou égal à deux, disposés électriquement en série et 2N diodes de puissance disposées N à N électriquement en série et en parallèle, formant des deuxième et troisième ensembles (ENS2, ENS3) de N diodes comprenant chacun N diodes électriquement en série, les deuxième et troisième ensembles (ENS2, ENS3) étant montés électriquement en parallèle entre-eux et en série avec les N interrupteurs en série, le premier ensemble (ENS1) de N interrupteurs en série étant disposé physiquement entre les deuxième et troisième ensembles (ENS2, ENS3) de N diodes en série; le bloc (60) de deux bras comprenant une alimentation électrique coplanaire (51), munie d'une ligne positive (DCBUS+) et d'une ligne négative (DCBUS-), disposée physiquement de manière à séparer deux bras du convertisseur, et comprenant une interface de puissance par bras (52, 56, 54, 58), chaque interface de puissance étant disposée physiquement de sorte que les deux demi-bras du bras correspondant sont situés entre l'alimentation électrique coplanaire (51) et l'interface de puissance correspondante (52, 56, 54, 58).

2. Convertisseur de puissance à découpage selon la revendication 1, dans lequel les interrupteurs du premier ensemble (ENS1) sont alignés et/ou les diodes du deuxième ensemble (ENS2) sont alignées et/ou les diodes du troisième ensemble (ENS3) sont alignées.

3. Convertisseur de puissance à découpage selon la revendication 2, dans lequel deux demi-bras formant un bras d'un bloc (60) de deux bras du convertisseur, comprennent un demi-bras positif (50, 57) comprenant l'ensemble (ENS1) de N interrupteurs en série connectés entre la ligne positive (DCBUS+) de l'alimentation électrique coplanaire (51) et l'interface de puissance correspondante (52, 56, 54, 58), et les deux ensembles (ENS2, ENS3) de N diodes connectées entre la ligne négative (DCBUS-) de l'alimentation électrique coplanaire (51) et l'interface de puissance correspondante (52, 56, 54, 58), et un demi-bras négatif (53, 55) comprenant l'ensemble (ENS1) de N interrupteurs en série connectés entre la ligne négative (DCBUS-) de l'alimentation électrique coplanaire (51) et l'interface de puissance correspondante (52, 56, 54, 58), et les deux ensembles (ENS2, ENS3) de N diodes connectées entre la ligne positive (DCBUS+) de l'alimentation électrique coplanaire (51) et l'interface de puissance correspondante (52, 56, 54, 58).

4. Convertisseur de puissance à découpage selon la revendication 3, dans lequel un demi-bras positif (50, 57) d'un bras d'un bloc de deux bras du convertisseur est disposé en vis-à-vis d'un demi-bras négatif (53, 55) d'un autre bras du convertisseur, par rapport à l'alimentation électrique coplanaire (51).

5. Convertisseur de puissance à découpage selon l'une des revendications précédentes, dans lequel, lorsque le nombre de bras est impair, le convertisseur comprend desdits blocs (60) de deux bras, et un bloc (60) de deux bras muni d'un bras additionnel (61, 65).

6. Convertisseur de puissance à découpage selon la revendication 5, dans lequel ledit bloc (60) de deux bras est muni d'un bras additionnel (61) comprenant deux demi-bras disposés de part et d'autre de l'alimentation électrique coplanaire (51) prolongée, et une interface de puissance (62) dudit bras additionnel (61) comprenant respectivement, pour chacun des deux demi-bras, une partie (62a, 62b) disposée de sorte que le demi-bras correspondant est situé entre l'alimentation électrique coplanaire (51) et ladite partie (62a, 62b) de l'interface de puissance correspondante (62).

7. Convertisseur de puissance à découpage selon la revendication 5, dans lequel ledit bloc (60) de deux bras muni d'un bras additionnel (65) comprend en outre, une portion additionnelle (51a) d'alimentation électrique coplanaire (51) disposée à une extrémité et dans une direction différente du reste de l'alimentation électrique coplanaire, et une interface de puissance (66) dudit bras additionnel (65) disposée de sorte que ledit bras additionnel (65) est situé entre ladite portion additionnelle (51a) d'alimentation électrique coplanaire et ladite interface de puissance (66) correspondante.

8. Convertisseur de puissance à découpage selon la revendication 7, dans lequel ladite portion additionnelle (51a) d'alimentation électrique coplanaire (51) est sensiblement perpendiculaire au reste de l'alimentation électrique coplanaire.

9. Convertisseur de puissance à découpage selon l'une des revendications précédentes, **caractérisé en ce qu'**il est hybride.

10. Convertisseur de puissance à découpage selon l'une des revendications précédentes, dans lequel les interrupteurs comprennent au moins un transistor bipolaire à grille isolée et/ou au moins un transistor à effet de champ à grille isolée.

11. Convertisseur de puissance à découpage selon l'une des revendications précédentes, dans lequel N vaut deux.

**12.** Convertisseur de puissance à découpage selon l'une des revendications précédentes, ledit convertisseur étant un onduleur ou un hacheur.

**13.** Système de commande d'au moins un vérin électrique d'un lanceur spatial comprenant au moins un convertisseur de puissance à découpage selon l'une des revendications précédentes, le récepteur électrique étant un moteur électrique et le convertisseur de puissance étant un onduleur.

**14.** Lanceur spatial muni d'un système selon la revendication 13.

**15.** Système de commande d'au moins un dispositif d'orientation d'antennes ou de panneaux solaires d'un satellite comprenant au moins un convertisseur de puissance à découpage selon l'une des revendications 1 à 14, le récepteur électrique étant un moteur électrique et le convertisseur de puissance étant un onduleur.

**16.** Satellite muni d'un système de commande selon la revendication 15.

**17.** Système d'alimentation d'un satellite comprenant au moins un convertisseur de puissance à découpage selon l'une des revendications 1 à 12, le récepteur électrique étant un transformateur polyphasé et le convertisseur de puissance étant un onduleur ou hacheur.

**18.** Satellite muni d'un système d'alimentation selon la revendication 17.

**Patentansprüche**

**1.** Leistungswandler mit Abschaltung, konfiguriert zum Steuern wenigstens einer Phase eines mehrphasigen elektrischen Empfängers mit wenigstens drei Phasen, umfassend wenigstens einen Block (60) von zwei Wandlerarmen, wobei jeder Wandlerarm-Halbarm eine erste Baugruppe (ENS1) von elektrisch in Serie angeordneten N Unterbrechern, wobei N gleich oder größer als zwei ist, und N zu N elektrisch in Serie und parallel angeordnete 2N Leistungsdioden umfasst, die eine zweite und eine dritte Baugruppe (ENS2, ENS3) von N Dioden bilden, die jeweils N elektrisch in Serie angeordnete Dioden umfassen, wobei die zweite und dritte Baugruppe (ENS2, ENS3) elektrisch parallel zueinander und in Serie mit den N Unterbrechern in Serie montiert sind, wobei die erste Baugruppe (ENS1) von N Unterbrechern physisch in Serie zwischen der zweiten und dritten Baugruppe (ENS2, ENS3) von N Dioden in Serie angeordnet ist; wobei der Block (60) von zwei Armen eine koplanare Stromversorgung (51), ausgestattet mit einer positiven Leitung (DCBUS+) und einer negativen Leitung (DCBUS-), physisch so angeordnet, dass sie zwei Arme des Wandlers trennen, und eine Leistungsschnittstelle pro Arm (52, 56, 54, 58) umfasst, wobei jede Leistungsschnittstelle physisch so angeordnet ist, dass sich die beiden Halbarme des entsprechenden Arms zwischen der koplanaren Stromversorgung (51) und der entsprechenden Leistungsschnittstelle (52, 56, 54, 58) befinden.

**2.** Leistungswandler mit Abschaltung nach Anspruch 1, bei dem die Unterbrecher der ersten Baugruppe (ENS1) ausgerichtet sind und/oder die Dioden der zweiten Baugruppe (ENS2) ausgerichtet sind und/oder die Dioden der dritten Baugruppe (ENS3) ausgerichtet sind.

**3.** Leistungswandler mit Abschaltung nach Anspruch 2, wobei zwei Halbarme, die einen Arm eines Blocks (60) von zwei Armen des Wandlers bilden, Folgendes umfassen:

- einen positiven Halbarm (50, 57), umfassend die Baugruppe (ENS1) von N Unterbrechern, die in Serie zwischen der positiven Leitung (DCBUS+) der koplanaren Stromversorgung (51) und der entsprechenden Leistungsschnittstelle (52, 56, 54, 58) geschaltet sind, und die zwei Baugruppen (ENS2, ENS2) von N Dioden, die zwischen der negativen Leitung (DCBUS-) der koplanaren Stromversorgung (51) und der entsprechenden Leistungsschnittstelle (52, 56, 54, 58) geschaltet sind, und
- einen negativen Halbarm (53, 55), umfassend die Baugruppe (ENS1) von N Unterbrechern, die in Serie zwischen der negativen Leitung (DCBUS-) der koplanaren Stromversorgung (51) und der entsprechenden Leistungsschnittstelle (52, 56, 54, 58) geschaltet sind, und die beiden Baugruppen (ENS2, ENS3) von N Dioden, die zwischen der positiven Leitung (DCBUS+) der koplanaren Stromversorgung (51) und der entsprechenden Leistungsschnittstelle (52, 56, 54, 48) geschaltet sind.

**4.** Leistungswandler mit Abschaltung nach Anspruch 3, bei dem ein positiver Halbarm (50, 57) eines Arms eines Blocks von zwei Armen des Wandlers gegenüber einem negativen Halbarm (53, 55) eines anderen Arms des Wandlers mit Bezug auf die koplanare Stromversorgung (51) angeordnet ist.

**5.** Leistungswandler mit Abschaltung nach einem der vorherigen Ansprüche, bei dem der Wandler, wenn die Zahl der Arme ungerade ist, Blöcke (60) von zwei Armen und einen Block (60) von zwei Armen mit einem zusätzlichen Arm (61, 65) umfasst.

6. Leistungswandler mit Abschaltung nach Anspruch 5, bei dem der Block (60) von zwei Armen mit einem zusätzlichen Arm (61) ausgestattet ist, umfassend zwei Halbarme, die auf beiden Seiten der verlängerten koplanaren Stromversorgung (51) angeordnet sind, und eine Leistungsschnittstelle (62) des zusätzlichen Arms (61), die jeweils, für jeden der zwei Halbarme, einen Teil (62a, 62b) umfasst, der so angeordnet ist, dass sich der entsprechende Halbarm zwischen der koplanaren Stromversorgung (51) und dem Teil (62a, 62b) der entsprechenden Leistungsschnittstelle (62) befindet.

7. Leistungswandler mit Abschaltung nach Anspruch 5, bei dem der Block (60) von zwei Armen, ausgestattet mit einem zusätzlichen Arm (65), ferner einen zusätzlichen Teil (51a) einer koplanaren Stromversorgung (51), angeordnet an einem anderen Ende und in einer anderen Richtung als der Rest der koplanaren Stromversorgung, und eine Leistungsschnittstelle (66) des zusätzlichen Arms (65) umfasst, so angeordnet, dass sich der zusätzliche Arm (65) zwischen dem zusätzlichen Teil (51a) der koplanaren Stromversorgung und der entsprechenden Leistungsschnittstelle (66) befindet.

8. Leistungswandler mit Abschaltung nach Anspruch 7, bei dem der zusätzliche Teil (51a) der koplanaren Stromversorgung (51) im Wesentlichen lotrecht zum Rest der koplanaren Stromversorgung ist.

9. Leistungswandler mit Abschaltung nach einem der vorherigen Ansprüche, **dadurch gekennzeichnet, dass** er hybrid ist.

10. Leistungswandler mit Abschaltung nach einem der vorherigen Ansprüche, bei dem die Unterbrecher wenigstens einen bipolaren Transistor mit isoliertem Gate und/oder wenigstens einen Feldeffekttransistor mit isoliertem Gate umfassen.

11. Leistungswandler mit Abschaltung nach einem der vorherigen Ansprüche, bei dem N gleich zwei ist.

12. Leistungswandler mit Abschaltung nach einem der vorherigen Ansprüche, bei dem der Wandler ein Wechselrichter oder ein Zerhacker ist.

13. System zum Steuern von wenigstens einem Elektroantrieb einer Trägerrakete, die wenigstens einen Leistungswandler mit Abschaltung nach einem der vorherigen Ansprüche umfasst, wobei der elektrische Empfänger ein Elektromotor ist und der Leistungswandler ein Wechselrichter ist.

14. Trägerrakete, ausgestattet mit einem System nach Anspruch 13.

15. System zum Steuern von wenigstens einer Ausrichtungsvorrichtung für Antennen oder Solarplatten eines Satelliten, umfassend wenigstens einen Leistungswandler mit Abschaltung nach einem der Ansprüche 1 bis 14, wobei der elektrische Empfänger ein Elektromotor ist und der Leistungswandler ein Wechselrichter ist.

16. Satellit, ausgestattet mit einem Steuersystem nach Anspruch 15.

17. System zum Versorgen eines Satelliten, umfassend wenigstens einen Leistungswandler mit Abschaltung nach einem der Ansprüche 1 bis 12, wobei der elektrische Empfänger ein mehrphasiger Transformator ist und der Leistungswandler ein Wechselrichter oder Zerhacker ist.

18. Satellit, ausgestattet mit einem Versorgungssystem nach Anspruch 17.

**Claims**

1. Switching power converter configured to control at least one phase of a polyphase electrical receiver at least at three phases, comprising at least one block (60) of two converter arms, wherein each converter arm half-arm comprises a first assembly (ENS1) of N switches, N being greater than or equal to two, arranged electrically in series and 2N power diodes which are arranged N to N electrically in series and in parallel, forming second and third assemblies (ENS2, ENS3) of N diodes each comprising N diodes which are electrically in series, the second and third assemblies (ENS2, ENS3) being mounted electrically in parallel with each other and in series with the N switches in series, the first assembly (ENS1) of N switches in series being arranged physically between the second and third assemblies (ENS2, ENS3) of N diodes in series; the block (60) of two arms comprising a coplanar electrical power supply (51), provided with a positive line (DCBUS+) and a negative line (DCBUS-) arranged physically so as to separate two arms of the converter, and comprising one power interface per arm (52, 56, 54, 58), each power interface being arranged physically so that the two half-arms of the corresponding arm are located between the coplanar electrical power supply (51) and the corresponding power interface (52, 56, 54, 58).

2. Switching power converter according to claim 1, wherein the switches of the first assembly (ENS1) are aligned and/or the diodes of the second assembly (ENS2) are aligned and/or the diodes of the third assembly (ENS3) are aligned.

3. Switching power converter according to claim 2, wherein two half-arms which form an arm of a block (60) of two arms of the converter comprise

- a positive half-arm (50, 57) comprising the assembly (ENS1) of N switches in series connected between the positive line (DCBUS+) of coplanar electrical power supply (51) and the corresponding power interface (52, 56, 54, 58), and the two assemblies (ENS2, ENS3) of N diodes connected between the negative line (DCBUS-) of the coplanar electrical power supply (51) and the corresponding power interface (52, 56, 54, 58), and

- a negative half-arm (53, 55) comprising the assembly (ENS1) of N switches in series connected between the negative line (DCBUS-) of the coplanar electrical power supply (51) and the corresponding power interface (52, 56, 54, 58), and the two assemblies (ENS2, ENS3) of N diodes connected between the positive line (DCBUS+) of the coplanar electrical power supply (51) and the corresponding power interface (52, 56, 54, 58).

4. Switching power converter according to claim 3, wherein a positive half-arm (50, 57) of an arm of a block of two arms of the converter is arranged opposite a negative half-arm (53, 55) of another arm of the converter, relative to the coplanar electrical power supply (51).

5. Switching power converter according to any one of the preceding claims, wherein, when the number of arms is uneven, the converter comprises blocks (60) of two arms, and a block (60) of two arms provided with an additional arm (61, 65).

6. Switching power converter according to claim 5, wherein the block (60) of two arms is provided with an additional arm (61) comprising two half-arms which are arranged at one side and the other of the extended coplanar electrical power supply (51), and a power interface (62) of the additional arm (61) comprising for each of the two half-arms, a portion (62a, 62b) arranged so that the corresponding half-arm is located between the coplanar electrical power supply (51) and the portion (62a, 62b) of the corresponding power interface (62), respectively.

7. Switching power converter according to claim 5, wherein the block (60) of two arms provided with an additional arm (65) further comprises an additional portion (51a) for coplanar electrical power supply (51) arranged at one end and in a different direction from the remainder of the coplanar electrical power supply, and a power interface (66) of the additional arm (65) arranged so that the additional arm (65) is located between the additional portion (51a) for coplanar electrical power supply and the corresponding power interface (66).

8. Switching power converter according to claim 7, wherein the additional portion (51a) for coplanar electrical power supply (51) is substantially perpendicular to the remainder of the coplanar electrical power supply.

9. Switching power converter according to any one of the preceding claims, **characterised in that** it is hybrid.

10. Switching power converter according to any one of the preceding claims, wherein the switches comprise at least one bipolar transistor with an insulated gate and/or at least one field effect transistor with an insulated gate.

11. Switching power converter according to any one of the preceding claims, wherein N is equal to two.

12. Switching power converter according to any one of the preceding claims, the converter being an inverter or a chopper.

13. System for controlling at least one electrical actuator of a space launcher comprising at least one switching power converter according to any one of the preceding claims, the electrical receiver being an electric motor and the power converter being an inverter.

14. Space launcher provided with a system according to claim 13.

15. System for controlling at least one antenna or solar panels orientation device of a satellite comprising at least one switching power converter according to any one of claims 1 to 14, the electrical receiver being an electric motor and the power converter being an inverter.

16. Satellite provided with a control system according to claim 15.

17. Satellite power supply system comprising at least one switching power converter according to any one of claims 1 to 12, the electrical receiver being a polyphase transformer and the power converter being an inverter or a chopper.

18. Satellite provided with a power supply system according to claim 17.

FIG.1a

FIG.1b

FIG.2a

Tension électrique (V)

Bras 2

Bras 1

$T_1$  $T_2$  $T_3$  $T_4$  $T_5$

Temps (s)

Période de commutation

T

FIG.2b

FIG.3a

EP 3 197 034 B1

FIG.3b

FIG.4a

FIG.4b

FIG.4c

51

57

DCBUS −    DCBUS +

ENS1

ENS3

I7   I8

D15  D16

E7  G7

E8  G8  C8

DT4

DIODE

DIODE

Anode

Anode

Cathode

Cathode

53a

IGBT

IGBT

G

G

E

E

C

C

53b

DIODE

DIODE

Anode

Anode

58

Cathode

Cathode

D13  D14

SORTIE DE PHASE

ENS2

FIG.4d

FIG.5a

FIG.5b

ENS3

ENS1                    ENS3

ENS1          D4    D3          51          I7  I8          D15 D16

I2  I1    E2 G2    E1 G1 C1    DT    DCBUS –    DCBUS +    E7 G7    E8 G8 C8    DT4    54

53b                                                                                                      ENS2

ENS2                                                                                                    D13 D14

D1  D2                                                                                                    53a

D12 D11                                                                                                  D8 D7

ENS3                                                                                                      ENS3

I6  I5

ENS1                                                                                                      I4  I3

52    DT3    C6 G6 E6    G5 E5    DT2    C3 G3 E3    G4 E4    ENS1

SORTIE DE
PHASE 1    D10 D9                                        SORTIE DE PHASE 2

ENS2                    D5    D6

ENS2

# FIG.5c

FIG.6a

FIG.6b

FIG.7a

FIG.7b

| ωt | I A | I B | I C |
|---|---|---|---|
| **0°** | 1 | -0.5 | -0.5 |
| **120°** | -0.5 | 1 | -0.5 |
| **240°** | -0.5 | -0.5 | 1 |
| **180°** | -1 | 0.5 | 0.5 |
| **300°** | 0.5 | -1 | 0.5 |
| **60°** | 0.5 | 0.5 | -1 |

Phase 1

Neutre

Phase 3

Phase 2

# FIG.8a

FIG.8b

FIG.8c

**RÉFÉRENCES CITÉES DANS LA DESCRIPTION**

**Documents brevets cités dans la description**

- WO 2015008333 A1
- US 2009285004 A1
- US 2015340962 A
- US 2015023084 A